# EUROPEAN PATENT APPLICATION

(11) **EP 4 835 613 A1**
(43) Date of publication of application: **04.11.2026**
(21) Application number: 26168226.4
(22) Date of filing: 26.03.2026
(51) Int. Cl.: G06F 1/26, G06F 1/30, H02J 9/06, H05K 7/14

(54) **POWER DISTRIBUTION SYSTEM FOR A MODULAR DATA CENTRE**

(71) Applicant: Sweet Project Holdings Limited, London, Greater London EC4M 7AU (GB)
(72) Inventor: Waugh, Andrew, London, EC4M 7AU (GB)
(74) Representative: Reddie & Grose LLP

(57) **Abstract**

A power distribution system (500) for a modular data centre (100) having a data hall (102) with a first end portion (114), a second end portion (116), and one or more middle portions (118) arranged in a repeating linear fashion, comprising: a plurality of power supply modules (502), each associated with a respective portion of the data hall (102); a plurality of switching units (516), each associated with a respective power supply module (502) and portion of the data hall (102), each comprising a first input terminal configured to receive electrical power from the associated power supply module (502); and a redundancy power supply module (504) configured to output electrical power to a second input terminal of each switching unit (516); wherein each switching unit (516) is configured to switch from outputting electrical power from the associated power supply module (502) to outputting electrical power from the redundancy power supply module (504) upon disruption to the electrical power provided by the associated power supply module (502).

## Description

### FIELD OF INVENTION

The present disclosure relates to power distribution infrastructure for data centres, and more particularly to a power distribution system for a modular data centre and a method for distributing power in a modular data centre.

### BACKGROUND

Data centres provide the computational infrastructure required to support modern digital services, including cloud computing, enterprise applications, and data storage. These facilities house large numbers of computer systems, networking equipment, and associated infrastructure within purpose-built buildings designed to provide appropriate power supply, cooling, and physical security. The power requirements of data centres are substantial, with facilities ranging from relatively modest installations requiring a few megawatts of electrical power to large-scale deployments requiring tens or hundreds of megawatts. Providing reliable electrical power to data centre facilities involves multiple systems including utility grid connections, backup generators, and various pieces of switchgear and power distribution equipment.

Modular approaches to data centre construction have been developed to address challenges associated with conventional construction methods. These approaches may involve prefabricating certain components or systems off-site and transporting them to the data centre location for installation. In modular data centre designs, the data hall may be constructed from repeating structural units or portions. This modular arrangement enables data centres to be scaled by adding or removing portions according to capacity requirements.

The power distribution architecture for modular data centres presents particular challenges. As the data hall is constructed from repeating portions that can be added or removed, the power supply infrastructure must similarly be capable of scaling in a corresponding manner to match the capacity of the data hall. Furthermore, data centre operators typically require redundancy in the power supply infrastructure to ensure continued operation in the event of a failure of any incoming power supply. Providing such redundancy whilst maintaining the modularity and scalability of the data centre design requires careful consideration of the power distribution topology.

Conventional approaches to providing redundancy in data centre power systems may involve duplicating the entire power supply infrastructure, such that each computer system receives power from two completely independent power supply paths. Whilst this approach provides a high level of redundancy, it can result in significant additional cost due to the additional power supply infrastructure, much of which will remain idle during normal operation.

It has been appreciated that a power distribution system is needed that overcomes one or more of these problems.

### SUMMARY

The invention is defined in the independent claims. Embodiments of the invention are set out in the dependent claims.

According to a first aspect, a power distribution system for a modular data centre is provided. The modular data centre has a data hall for housing a plurality of computer systems, the data hall having a first end portion, a second end portion, and one or more middle portions arranged in a repeating linear fashion between the first end portion and the second end portion so as to form the data hall. The power distribution system comprises: a plurality of power supply modules, wherein each power supply module is associated with a respective one of the portions of the data hall; a plurality of switching units, wherein each switching unit is associated with a respective one of the plurality of power supply modules and the associated portion of the data hall, and wherein each switching unit comprises a first input terminal configured to receive electrical power from a first output terminal of the associated power supply module; and a redundancy power supply module configured to output electrical power to a second input terminal of each of the plurality of switching units; wherein each switching unit further comprises an output terminal configured to output electrical power for one or more computer systems within the associated portion of the data hall, and wherein each switching unit is configured to switch from outputting electrical power provided by the associated power supply module to outputting electrical power provided by the redundancy power supply module upon a disruption to the electrical power provided by the associated power supply module.

The claimed invention addresses the challenges of providing redundancy in modular data centre power systems whilst maintaining scalability. By associating each power supply module with a respective portion of the data hall and providing a shared redundancy power supply module that can supply back up power should the power supply from any of the individual power supply modules fail, the power distribution system enables redundancy without requiring duplication of the entire power supply infrastructure for each portion. The switching units enable automatic transfer between the power supply module associated with each portion of the data centre and the redundancy power supply module, ensuring continued operation of the computer systems in the event of a failure of any individual power supply module. Furthermore, as the data hall is extended by adding additional middle portions during the design phase, each additional portion has its own associated power supply module and switching unit, with the redundancy power supply module providing backup capability across all portions, thereby maintaining the modularity and scalability of the data centre design.

Each of the power supply modules and/or the redundancy power supply module may comprise: an external supply input terminal configured to receive electrical power from an external power supply; and a transformer configured to convert a voltage of the electrical power received from the external power supply.

This configuration enables the power supply modules to receive power from a utility or grid connection and convert the voltage to levels suitable for distribution within the data centre, providing the primary source of electrical power during normal operation.

The external power supply may be a utility power supply or a grid power supply.

This enables the modular data centre to operate primarily from utility grid power, which is typically more cost-effective and reliable than generator-based power during normal operating conditions.

Each of the power supply modules and/or the redundancy power supply module may comprise: a generator unit configured to provide power during a failure of the external power supply.

The inclusion of a generator unit provides backup power capability, enabling continued operation of the data centre during utility grid outages or maintenance periods.

The generator unit may provide a power between 1.5MW and 10MW, preferably between 2MW and 5MW, more preferably wherein the generator unit is a 2.4MW generator. This power range is suitable for providing backup power to a portion of a modular data centre, with the specific generator capacity selected to match the power requirements of the associated data hall section.

The first output terminal of each power supply module may be connected to a switchboard within that power supply module. The switchboard distributes the electrical power from the incoming power sources (i.e. from the external power supply via the transformer, or from the generator unit) to downstream equipment within the data centre via the first output terminal.

The first output terminal of each power supply module may be coupled to one or more uninterruptible power supply systems within that power supply module.

The one or more uninterruptible power supply systems maintain continuity of the power supply output by the first output terminal, for example during transitions between the external power supply and the generator unit. Thus the one or more uninterruptible power supply systems prevent interruption to power supply to the computer systems within the data hall from the first output terminal, even is there is a disruption to the incoming external power supply. Further, the use of multiple uninterruptible power supply systems is beneficial for redundancy purposes, as the failure of one uninterruptible power supply system does not result in a complete loss of uninterruptible power supply capability. Additionally, the use of multiple uninterruptible power supply systems enables each individual uninterruptible power supply system to be smaller, reducing the size and cost of each unit whilst collectively providing the required power capacity.

Each of the plurality of power supply modules may be identical.

The use of identical power supply modules enables mass production efficiencies, reducing per-unit manufacturing costs and simplifying procurement, maintenance, and spare parts management.

Each of the plurality of power supply modules may be structurally separate from the associated portion of the data hall.

This structural separation provides safety benefits and facilitates maintenance access to both the power supply modules and the data hall structure, as well as providing increased fire safety by separating flammable components in the power supply modules (such as fuel tanks and batteries) from the data hall.

The redundancy power supply module may be structurally separate from the data hall.

This structural separation provides the same safety and maintenance benefits for the redundancy power supply module as for the primary power supply modules.

The redundancy power supply module may be connected to the second input terminal of each of the plurality of switching units via a redundancy busbar.

The use of a redundancy busbar simplifies the electrical connections between the redundancy power supply module and the plurality of switching units, enabling a single redundancy power supply module to serve multiple portions of the data hall efficiently.

Each of the plurality of switching units may be a static transfer switch or an automatic transfer switch.

Static transfer switches and automatic transfer switches provide rapid transfer capability between power sources, with transfer times sufficiently rapid to prevent interruption to the power supply output downstream for the computer systems in the data hall.

The power distribution system may further comprise: a plurality of first power distribution units, wherein each first power distribution unit is associated with a respective one of the plurality of switching units and the associated portion of the data hall; wherein the output terminal of each switching unit is connected to the associated first power distribution unit; and wherein each first power distribution unit is configured to transfer electrical power output by the associated switching unit to the one or more computer systems within the associated portion of the data hall.

The first power distribution units provide a further level of power distribution between the switching units and the computer systems, enabling circuit protection and monitoring at the data rack row level within the data hall.

The power distribution system may further comprise: a plurality of second power distribution units, wherein each second power distribution unit is associated with a respective one of the plurality of power supply modules and the associated portion of the data hall; wherein each power supply module comprises a second output terminal, and each second power distribution unit is connected to the second output terminal of the associated power supply module; and wherein each second power distribution unit is configured to transfer electrical power output by the second output terminal of the associated power supply module to the one or more computer systems within the associated portion of the data hall.

The second power distribution units and second output terminals provide a second path for electrical power from each power supply module to the computer systems, in addition to the path via the switching unit and first power distribution unit. This arrangement provides dual-feed redundancy for the one or more computer systems, wherein each computer system can receive power from either the first power distribution unit or the second power distribution unit. Thus if both power supplies provided to the switching unit were to fail (i.e. both the power output by the first output terminal and the redundancy power supply module were to fail), the one or more computer systems could still receive electrical power via the second output terminal and the second power distribution unit. Thus this arrangement further enhances the reliability of the power supply to the computer systems within the data hall.

The second output terminal of each power supply module may be connected to a switchboard within that power supply module. The switchboard distributes the electrical power from the incoming power sources (i.e. from the external power supply via the transformer, or from the generator unit) to downstream equipment within the data centre via the second output terminal. In some embodiments, a shared switchboard may be used for the first and second output terminals. Alternatively, each of the first have second output terminals can have a separate dedicated switchboard to provide additional useful redundancy, as if one switchboard were to fail it would not cause both of the first and second output terminals to fail (as would be the case if the output terminals both exited the same shared switchboard).

The second output terminal of each power supply module may be coupled to one or more uninterruptible power supply systems within that power supply module.

The one or more uninterruptible power supply systems coupled to the second output terminal maintain continuity of the power supply output by the second output terminal, for example during transitions between the external power supply and the generator unit. This ensures that the power supplied via the second output terminal to the computer systems remains uninterrupted even during power source transitions, further enhancing the reliability of the power distribution system. The one or more uninterruptible power supply systems coupled to the second output terminal may be the same uninterruptible power supply systems as those coupled to the first output terminal, or may be different uninterruptible power supply systems to provide additional redundancy.

The one or more computer systems may be arranged in one or more rows, preferably in three rows, six rows, or twelve rows. This row-based arrangement facilitates efficient organisation of the computer systems, with the number of rows selected based on the requirements for that portion of the data hall.

Each row may comprise computer systems that either: require an average power of 250 kW, 375 kW, or 750 kW; have a maximum power requirement of 300 kW, 500kW, or 1000kW; or both.

These power specifications are selected to accommodate typical computing workloads while providing headroom for peak demand periods. Further, these power specifications align with the modular power supply architecture, wherein each power supply module is configured to provide sufficient capacity for the associated portion of the data hall, supporting the scalability of the modular data centre design.

Each of the one or more rows may comprise a first power supply busbar configured to receive power from the first power distribution unit.

The use of busbars for power distribution within each row simplifies the electrical connections to individual computer systems and enables efficient power distribution along the length of each row.

Each of the one or more rows may comprise a second power supply busbar configured to receive power from the second power distribution unit.

The provision of a second power supply busbar enables dual-feed redundancy at the row level, with each row receiving power from two independent sources. In particular, the first power supply busbar provides power received from either the first output terminal or the redundancy power supply module (via the switching unit and first power distribution unit), and the second power supply busbar provides power received from the second output terminal of the power supply module (via the second power distribution unit). The dual-feed redundancy means that even if the power supply from both the first output terminal and the redundancy power supply were to fail, power would still be available from the second output terminal. Similarly, if the power supply from the second output terminal were to fail, power would still be available from the first output terminal or from the redundancy power supply via the switching unit.

The one or more computer systems may be configured to selectively draw power from either the first power supply busbar or the second power supply busbar.

This capability to selectively draw power from either power supply busbar enables each computer system to automatically transfer between power sources in the event of lack of power to one of the power supply busbars, providing redundancy at the individual computer system level.

The power distribution system may further comprise: a plurality of additional switching units, wherein each additional switching unit is associated with a respective one of the power supply modules and the associated portion of the data hall; wherein each additional switching unit comprises a first input terminal configured to receive electrical power from the first output terminal of the associated power supply module; wherein each additional switching unit comprises a second input terminal configured to receive electrical power from the redundancy power supply module; and wherein each additional switching unit further comprises an output terminal configured to output electrical power to one or more additional computer systems within the associated portion of the data hall, and wherein each additional switching unit is configured to switch from outputting electrical power provided by the associated power supply module to outputting electrical power provided by the redundancy power supply module upon a disruption to the electrical power provided by the associated power supply module.

The provision of additional switching units enables the power distribution system to serve additional computer systems within each portion of the data hall whilst maintaining the same redundancy capability provided by the redundancy power supply module. Having multiple switching units associated with each power supply module (i.e. the switching unit and additional switching unit) provides benefits in terms of load distribution and maintenance. The power load from the associated portion of the data hall can be shared across the multiple switching units, reducing the current carried by each individual switching unit and enabling the use of smaller, lower power rated switching equipment. Additionally, the provision of multiple switching units facilitates maintenance operations, as each switching unit serves only a subset of the rows within the associated portion of the data hall rather than all rows. Thus maintenance or replacement of one switching unit affects only the rows served by that switching unit, reducing the operational impact of maintenance activities.

Each of the plurality of additional switching units may be a static transfer switch or an automatic transfer switch.

Static transfer switches and automatic transfer switches provide rapid transfer capability between power sources, with transfer times sufficiently rapid to prevent interruption to the power supply output downstream for the additional computer systems in the data hall.

For each of the power supply modules the first output terminal may be connected to both the first input terminal of the associated switching unit and the first input terminal of the associated additional switching unit via a primary busbar.

The use of a primary busbar simplifies the electrical connections between each power supply module and its associated switching units, enabling efficient distribution of power from the first output terminal to multiple switching units.

The redundancy power supply module may be connected to the second input terminal of each of the plurality of additional switching units via the redundancy busbar.

This arrangement enables the redundancy power supply module to provide backup power to both the switching units and the additional switching units via a single redundancy busbar, simplifying the electrical topology whilst maintaining redundancy capability.

The power distribution system may further comprise: a plurality of third power distribution units, wherein each third power distribution unit is associated with a respective one of the plurality of additional switching units and the associated portion of the data hall; wherein the output terminal of each additional switching unit is connected to the associated third power distribution unit; and wherein each third power distribution unit is configured to transfer electrical power output by the associated additional switching unit to the one or more additional computer systems within the associated portion of the data hall.

The third power distribution units provide a further level of power distribution between the additional switching units and the additional computer systems, enabling circuit protection and monitoring at the row level for the additional computer systems.

The power distribution system may further comprise: a plurality of fourth power distribution units, wherein each fourth power distribution unit is associated with a respective one of the plurality of power supply modules and the associated portion of the data hall; wherein each power supply module comprises a third output terminal, and each fourth power distribution unit is connected to the third output terminal of the associated power supply module; and wherein each fourth power distribution unit is configured to transfer electrical power output by the third output terminal of the associated power supply module to the one or more additional computer systems within the associated portion of the data hall.

The fourth power distribution units and third output terminals provide dual-feed redundancy at the additional computer system level, analogously to as described above for the second power distribution units and second output terminals.

The third output terminal of each power supply module may be connected to a switchboard within that power supply module. The switchboard distributes the electrical power from the incoming power sources (i.e. from the external power supply via the transformer, or from the generator unit) to downstream equipment within the data centre via the third output terminal. In some embodiments, a shared switchboard may be used for the first, second and third output terminals. Alternatively, some or all of the first, second and third output terminals can have a separate dedicated switchboard to provide additional redundancy.

The third output terminal of each power supply module may be coupled to one or more uninterruptible power supply systems within that power supply module.

The one or more uninterruptible power supply systems coupled to the third output terminal maintain continuity of the power supply output by the third output terminal, for example during transitions between the external power supply and the generator unit. The one or more uninterruptible power supply systems coupled to the third output terminal may be the same uninterruptible power supply systems as those coupled to the first and/or second output terminals, or may be different uninterruptible power supply systems to provide additional redundancy.

The one or more additional computer systems may be arranged in one or more rows, preferably in three rows, six rows, or twelve rows. This row-based arrangement facilitates efficient organisation of the additional computer systems, with the number of rows selected based on the requirements for that portion of the data hall.

Each row may comprise computer systems that either: require an average power of 250 kW, 375 kW, or 750 kW; have a maximum power requirement of 300 kW, 500kW, or 1000kW; or both.

These power specifications are selected to accommodate typical computing workloads while providing headroom for peak demand periods. Further, these power specifications align with the modular power supply architecture, wherein each power supply module is configured to provide sufficient capacity for the associated portion of the data hall, supporting the scalability of the modular data centre design.

Each of the one or more rows of additional computer systems may comprise a first power supply busbar configured to receive power from the third power distribution unit.

Each of the one or more rows of additional computer systems may comprise a second power supply busbar configured to receive power from the fourth power distribution unit.

The one or more additional computer systems may be configured to selectively draw power from either the first power supply busbar or the second power supply busbar.

The advantages discussed above for the first and second power supply busbars and selective power drawing capability apply analogously for the one or more additional computer systems.

Each of the power supply modules and/or the redundancy power supply module may comprise one or more additional output terminals configured to output electrical power to plant equipment within the data centre.

This arrangement enables the power supply modules to provide power for building services and mechanical equipment in addition to the IT equipment, ensuring that all power requirements of the data centre are met by the modular power supply infrastructure.

The plant equipment may comprise: heating, ventilation, and/or air conditioning equipment, loading bay equipment, Meet-Me Room equipment, equipment in an administrative building of the data centre, equipment in a logistic building of the data centre, or any combination thereof.

Thus the power supply modules can serve all ancillary facilities within the data centre, in addition to supplying power for the computer systems.

Each of the power supply modules and/or the redundancy power supply module may be configured to provide either or both of 1.5 MW of IT power and 2.4 MW of total power.

These power specifications are selected to align with readily available generator and electrical equipment sizes, enabling faster procurement and deployment compared to custom-specified power systems. Further, these power specifications align with the modular power supply architecture, wherein each power supply module is configured to provide sufficient capacity for the associated portion of the data hall, supporting the scalability of the modular data centre design.

The data centre may be configured to provide an IT power of 1.5 MW, 3 MW, 4.5 MW, 9 MW, 18 MW, 27 MW, 36 MW, 45 MW, 54 MW, 72MW or 108 MW. These power levels represent multiples of the base 1.5 MW module, demonstrating the scalability of the modular approach from small installations to large-scale deployments.

According to a second aspect, a method for distributing power in a modular data centre is provided. The modular data centre has a data hall for housing a plurality of computer systems, the data hall having a first end portion, a second end portion, and one or more middle portions arranged in a repeating linear fashion between the first end portion and the second end portion so as to form the data hall. The method comprises the steps of: receiving, by each of a plurality of switching units, electrical power from a respective power supply module associated with that switching unit; receiving, by each of the plurality of switching units, electrical power from a redundancy power supply module; outputting, by each of the plurality of switching units, the electrical power received from the associated power supply module for one or more computer systems within a portion of the data hall that is associated with that switching unit and the associated power supply module; detecting, by a first of the plurality of switching units, a disruption to the electrical power received by that switching unit from the associated power supply module; and switching, by the first of the plurality of switching units in response to the detecting, to outputting the electrical power received from the redundancy power supply module to the one or more computer systems.

This method enables automatic transfer between primary and redundancy power supplies in the event of a disruption, ensuring continued operation of the computer systems within the data hall. The method maintains the modularity and scalability of the data centre design by associating each switching unit with a respective power supply module and portion of the data hall, whilst providing shared redundancy capability through the redundancy power supply module.

### BRIEF DESCRIPTION OF FIGURES

Embodiments of the invention will be described, by way of example, with reference to the following drawings, in which:
FIG. 1 illustrates an isometric view of a modular data centre.
FIG. 2 illustrates an isometric view of the modular data centre of FIG. 1
FIG. 3 illustrates a floor plan view of the modular data centre of FIG. 1.
FIG. 4 illustrates an isometric view of a sub-hall of the modular data centre of FIG. 1.
FIG. 5 illustrates a floor plan view of a sub-hall of a modular data centre.
FIG. 6 illustrates an isometric view of a power supply module arrangement.
FIG. 7 illustrates an isometric view of a power supply module.
FIG. 8 illustrates a rear isometric view of the power supply module of FIG. 7.
FIG. 9 illustrates a floor plan view of a first container of the power supply module of FIG. 7.
FIG. 10 illustrates a floor plan view of a second container of the power supply module of FIG. 7.
FIG. 11 illustrates a schematic diagram of a power distribution system for a modular data centre.
FIG. 12 illustrates a schematic diagram showing further connections of a redundancy power supply module of the power distribution system of FIG 11.
FIG. 13 illustrates a flowchart of a method for distributing power in a modular data centre.

Common reference numerals are used throughout the figures to indicate similar features.

### DETAILED DESCRIPTION

### Modular Data Centre

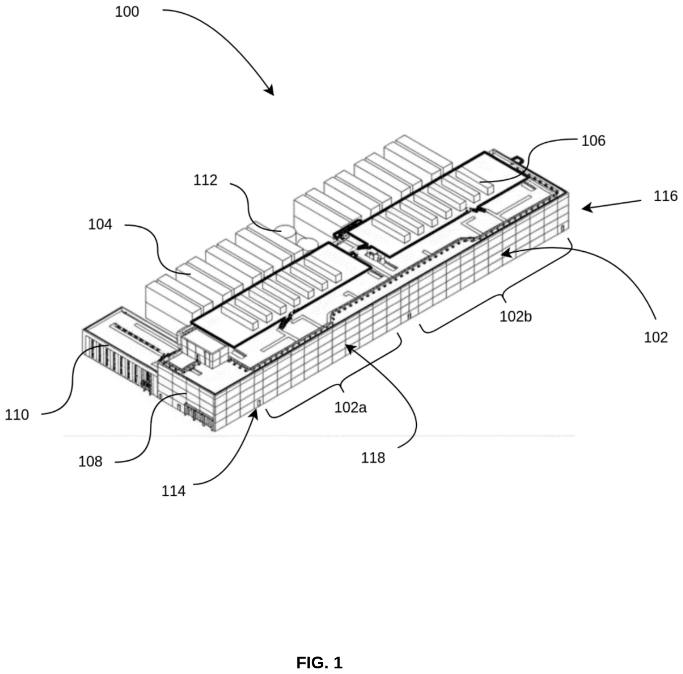

FIG. 1 illustrates an isometric view of a modular data centre 100. The modular data centre 100 comprises a data hall 102 configured to house a plurality of computer systems. The data hall 102 is divided into a first sub-hall 102a and a second sub-hall 102b. The first sub-hall 102a and the second sub-hall 102b may be configured to operate independently, enabling the data hall 102 to serve two different clients independently when the data hall 102 is split down the middle.

A plurality of power supply modules 104 are arranged linearly adjacent to the data hall 102. Each power supply module 104 is structurally separate from the data hall 102, with a gap between each power supply module 104 and the data hall 102. The power supply modules 104 are configured to provide electrical power to the data hall 102.

A plurality of modular cooling units 106 are positioned on the roof of the data hall 102. The modular cooling units 106 are arranged in rows along the length of the data hall 102 and are configured to provide cooling to the data hall 102.

Sprinkler water tanks 112 are located near the power supply modules 104. sprinkler water tanks 112 are configured to supply water for a sprinkler fire suppression system of the modular data centre 100.

A logistics building 108 is attached at one end of the data hall 102. The logistics building 108 shares the same width as the data hall 102. The logistics building 108 may house lifts, stores, delivery entrances, and other functional sections required for operation of modular data centre 100. An administrative building 110 is positioned adjacent to the logistics building 108. The administrative building 110 is configured to house personnel and administrative functions associated with the modular data centre 100. For example, the administrative building 110 may take the form of an office building.

The data hall 102 includes a first end portion 114 at one end, a second end portion 116 at the opposite end, and one or more middle portions 118 arranged in a repeating linear fashion between the first end portion 114 and the second end portion 116. Each of the first end portion 114, the second end portion 116, and the middle portions 118 has a respective power supply module 104 associated with the respective portion. The respective power supply module 104 is configured to provide a power required by the associated portion when the modular data centre 100 is in operation. As illustrated, each of the first end portion 114, the second end portion 116, and the middle portions 118 has two power supply modules 104 associated with it, though in some cases more or fewer power supply modules 104 may be associated with each portion. In some cases, each portion may be able to have a different number of power supply modules 104 associated with it.

The modular data centre 100 illustrated in FIG. 1 is an exemplary configuration. The modular data centre 100 is configured to accommodate different numbers of middle portions 118 to change the size of the data hall 102. More middle portions 118 are included to increase the capacity of the data hall 102, or fewer middle portions 118 are included to decrease the capacity of the data hall 102. The modular data centre 100 is also configured to accommodate different numbers of sub-halls 102a, 102b to change the overall size of the modular data centre 100.

The use of repeatable portions of the data hall 102 provides significant advantages in the design and construction of data centres with varying capacities. By employing a standard template comprising the first end portion 114, the second end portion 116, and standardised middle portions 118, data halls of different sizes can be readily designed without requiring bespoke engineering work for each project. The middle portions 118 may each have the same structure, enabling efficient manufacturing and construction processes where identical components can be mass-produced and assembled in a repeatable manner. This standardisation reduces design time, as the structural, electrical, and cooling requirements of each middle portion 118 are predetermined and factored into the design of each portion, and so are automatically scaled as needed. Furthermore, the association of each portion with its own power supply module 104 ensures that power capacity scales proportionally with the data hall 102 size, eliminating the need for complex recalculations of power infrastructure when adjusting data centre capacity. The repeatable nature of the middle portions 118 also simplifies procurement and logistics, as the same prefabricated components can be ordered in varying quantities depending on the required data hall 102 capacity, enabling faster deployment timelines compared to traditional bespoke construction approaches.

The modular data centre 100 is configured to accommodate different numbers of floors. The data hall 102 comprises one floor, two floors, or three floors depending on the capacity requirements. Each floor typically is similar to the floors below, with repetition in the fittings and may of the structural or facade elements of the modular data centre 100.

Fire travel distances within the modular data centre 100 are maintained within acceptable regardless of the number of floors or adjacent data halls added. This is due to the repeating, linear arrangement of the middle portions 118, whereby adding more middle portions 118 extends the data hall 102 in the length direction without adversely affecting the fire travel distances within each portion. Furthermore, due to the modular nature of the prefabricated wall panels, additional door panels can be added easily and as need to meet safety requirements as the modular data centre 100 is scaled.

The modular data centre 100 may be configured to accommodate different operator rack layouts. For example, the data hall 102 may be configured to accommodate operators such as Amazon, Google, Microsoft and Oracle rack configurations within the first sub-hall 102a and the second sub-hall 102b.

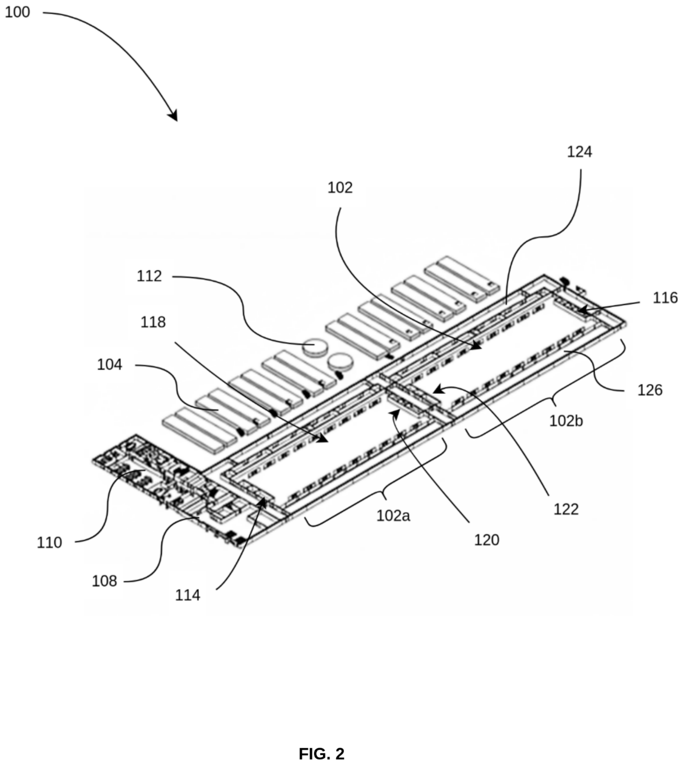

FIG. 2 illustrates an isometric view of the modular data centre 100 showing the spatial arrangement of the data hall 102, the power supply modules 104, and supporting facilities. The power supply modules 104 are arranged linearly and adjacent to the data hall 102, with a gap separating the power supply modules 104 from the data hall 102. The gap provides structural separation between the power supply modules 104 and the data hall 102. The power supply modules 104 are often positioned on the perimeter of data centre site, and may include screening cladding for visual screening from neighbouring properties.

A service corridor 124 runs along one edge of the data hall 102 adjacent to the power supply modules 104. The service corridor 124 extends through the first end portion 114, the second end portion 116, and the middle portions 118 along the edge of the data hall 102 that is adjacent to the power supply modules 104. The service corridor 124 is configured to house main services distribution, including pipework, ductwork, power line containment, and data line containment. The service corridor 124 contains static transfer switches positioned along the back wall for power distribution.

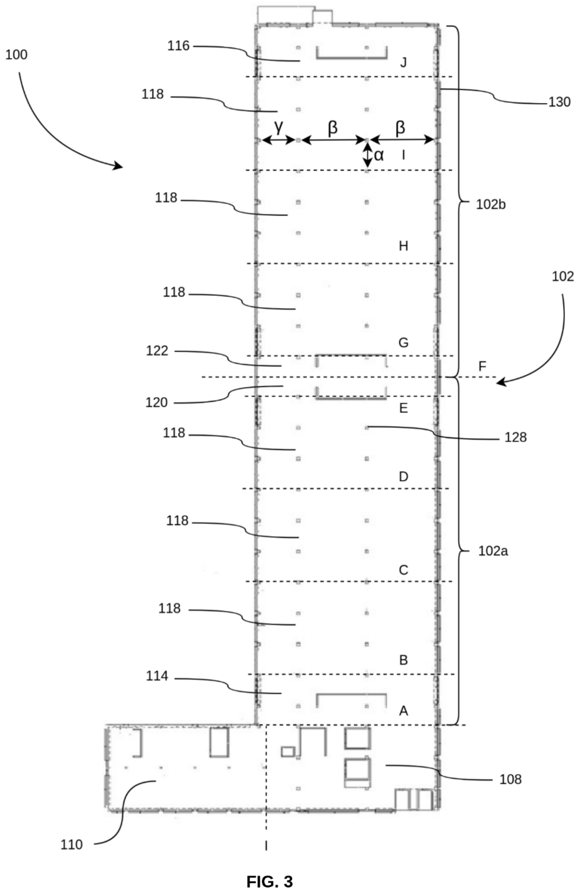

The service corridor 124 has a width of 4 metres compared to typical 3 metre corridors. The relatively large width of the service corridor 124, compared to typical service corridors, has been selected to accommodate installation, maintenance, and health and safety requirements. The column grid of the data hall 102 includes a 7 metre spacing anomaly instead of the standard 6080 mm spacing to accommodate the service corridor 124, as discussed further in relation to FIG. 3. The size of the service corridor 124 is particularly beneficial in providing the space to enable the installation of prefabricated, modular main services distribution modules.

The prefabricated main services distribution modules may be manufactured off-site and installed within the service corridor 124. The main services distribution modules may contain pipework, ductwork, power line containment, and data line containment. In some cases, the main services distribution modules may be approximately 6 metres in length and are configured to be hoisted into position and connected at regular intervals along the service corridor 124. This approach improves site safety by a reduction of site activities and hence the need for workers to install services overhead at height, as the modules are assembled at ground level in a factory environment before being transported to site and raised into position on site. The main services distribution modules may also be pre-commissioned and pre-tested before installation, increasing quality and reliability.

A cooling corridor 126 is located at one end of the data hall 102. The cooling corridor 126 functions as a plant room area where modular cooling units serving the data hall 102 environment are located. The cooling corridor 126 may include one or more prefabricated service modules. The prefabricated service modules may be manufactured off-site and installed within the cooling corridor 126. The use of prefabricated service modules enables rapid installation of mechanical and electrical plant equipment, as well as cost savings due to the use of standardised service modules that can be produced at scale for multiple different data centres, rather than designing bespoke service modules for each data centre. As with the prefabricated main services distribution modules, these prefabricated service modules may also be pre-commissioned and pre-tested before installation, increasing quality and reliability, and may be "plug and play".

A first intermediate portion 120 and a second intermediate portion 122 are positioned adjacent to one another between the middle portions 118. The first intermediate portion 120 and the second intermediate portion 122 are configured to separate the data hall 102 into the first sub-hall 102a and the second sub-hall 102b. The data hall 102 is symmetric in layout about the join between the first intermediate portion 120 and the second intermediate portion 122. The symmetric layout enables the first sub-hall 102a and the second sub-hall 102b to be configured identically, facilitating independent operation of each sub-hall for different clients.

The size of each sub-hall 102a, 102b may be based on a power supply redundancy requirement of a data hall operator. Each sub-hall 102a, 102b may be sized to accommodate a specific number of power supply modules 104 (through the number of middle portions 118) along with one or more redundancy power supply modules according to the operator's specifications. For example, if an operator has a requirement of one redundant power supply module for every six power supply modules, then the data hall 102 may be sized so as to have six power supply modules 104 in each sub-hall 102a, 102b along with one redundancy power supply module. This configuration enables each sub-hall 102a, 102b to have its own redundancy power supply according to the operator's specifications.

FIG. 3 illustrates a floor plan view of the modular data centre 100 showing key structural features, in particular columns 128 and external wall panels 130. The data hall 102 extends vertically across the plan with a series of regularly spaced columns 128 arranged in a grid pattern throughout the structure. External wall panels 130 form the perimeter walls of the data hall 102.

The columns 128 are arranged with consistent spacing indicated by Greek letters in FIG. 3. The symbol α represents a first common spacing between columns 128 in the length direction of the data hall 102. The first common spacing α is 6080 mm. The symbol β represents a second common spacing between columns 128 in the width direction of the data hall 102. The second common spacing β is 12160 mm, which is double the first common spacing α.

The first common spacing α and the second common spacing β have been found to enable the data hall 102 to accommodate different computer rack configurations used by different computing equipment providers and data centre operators, including hyperscalers such as Google, Microsoft, Amazon, and Oracle. The column spacings were carefully considered to ensure that the data hall 102 can accommodate the latest cabinet layouts, cabinet sizes, and the different operator requirements for spacing between cabinets. This enables the data centre to serve multiple different client requirements without structural modifications. The ability to accommodate different operators without structural modifications provides significant advantages. A single standardised data hall plan can be deployed across multiple different sites, reducing design costs and enabling faster deployment timelines. Furthermore, a single site can accommodate different operators within different sub-halls or tenant areas, with each operator's specific rack configuration fitting within the same structural grid. Additionally, if an operator vacates a portion of the data hall, the space can be readily repurposed for a different operator with different rack requirements without the need for costly and time-consuming structural alterations or the compromising of rack row quantities. This flexibility maximises the commercial utility of the data centre infrastructure and reduces the risk associated with long-term facility investments.

The symbol γ represents a third spacing between columns 128, which is 7000 mm. The third spacing γ accommodates the 4 metre width of the service corridor 124, as described above in relation to FIG. 2.

Dashed lines A to J are shown across the width of the data hall 102 in FIG. 3 to delineate the different portions of the data hall 102. The first end portion 114 is located between dashed lines A and B. The second end portion 116 is located at the opposite end of the data hall 102 after dashed line J. The first intermediate portion 120 is positioned between dashed lines E and F. The second intermediate portion 122 is positioned between dashed lines F and G, adjacent to the first intermediate portion 120. The first intermediate portion 120 and the second intermediate portion 122 separate the first sub-hall 102a from the second sub-hall 102b. Middle portions 118 are arranged between the first end portion 114 and the second end portion 116, and more particularly between the first end portion 114 and the first intermediate portion 120 and between the second intermediate portion 122 and the second end portion 116.

The size of the data hall 102 is varied by changing the number and arrangement of the middle portions 118. Additional middle portions 118 are added between the first end portion 114 and the first intermediate portion 120 to increase the size of the first sub-hall 102a. Additional middle portions 118 are added between the second intermediate portion 122 and the second end portion 116 to increase the size of the second sub-hall 102b. The first end portion 114, the second end portion 116, and adjacent middle portions 118 share columns 128 along boundaries between portions in the width direction. Accordingly, it will be appreciated that these are not necessarily structurally independent modules, but are designed in a repeatable manner such that the data hall plan can be easily made to any size specification required. Similarly, as the first intermediate portion 120 will often, in practice, always be adjacent to the second intermediate portion 122, these two portions can be treated together as a joint module, reflected in the fact that there is no line of columns between them (e.g., along line F).

At the bottom of the floor plan in FIG. 3, the logistics building 108 is attached to the data hall 102. The logistics building 108 shares the same width as the data hall 102. The logistics building 108 is configured to house functional areas required for the operation of the modular data centre 100, including lifts, stores, delivery entrances, loading bays, and goods handling facilities. The logistics building 108 provides a centralised location for receiving and distributing equipment, supplies, and replacement components to the data hall 102. The attachment of the logistics building 108 to the data hall 102 enables efficient movement of equipment and personnel between the two structures without requiring external transit.

Dashed line I separates the administrative building 110 from the logistics building 108. The administrative building 110 is positioned adjacent to the logistics building 108. The administrative building 100 functions as an office for the modular data centre 100, and uses a smaller structural grid of approximately 4 metres by 3 metres compared to the grid of the data hall 102. The administrative building 110 has a reduced floor-to-floor height of 4 metres compared to the 6 metre floor-to-floor height of the data hall 102. The administrative building 110 can configured for volumetric modularisation similar to portacabins, enabling rapid assembly from prefabricated volumetric units.

The smaller structural grid of the administrative building 110 is appropriate for office accommodation, where the spatial requirements differ from those of the data hall 102. Office spaces typically require smaller column-free spans to accommodate partition walls, individual offices, meeting rooms, and circulation corridors. The 4 metre by 3 metre grid provides sufficient flexibility for typical office layouts whilst enabling the use of lighter structural elements compared to the data hall 102. The reduced floor-to-floor height of 4 metres is similarly appropriate for office accommodation, where the ceiling heights required for computing equipment, cable management, and cooling infrastructure are not necessary. This differentiation in structural grid and floor height between the administrative building 110 and the data hall 102 enables each building to be optimised for its intended function whilst still benefiting from prefabricated construction methods.

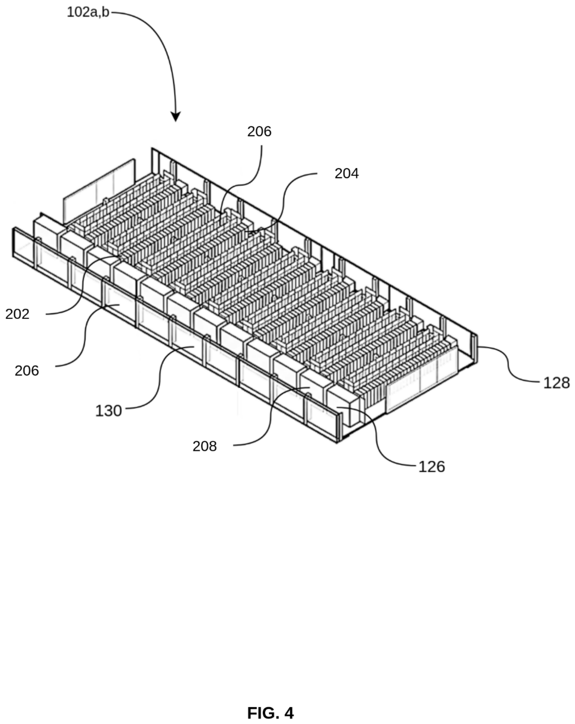

FIG. 4 illustrates an isometric view of a sub-hall 102a, 102b of the modular data centre 100 showing the arrangement of computer systems within the sub-hall 102a, 102b. The sub-hall 102a, 102b comprises a plurality of computer systems 202 arranged in rows 204. Each row 204 contains multiple computer systems 202 positioned in a linear arrangement across the width of the sub-hall 102a, 102b.

The rows 204 are organised in pairs, with each pair of rows 204 having a hot aisle 06 positioned between the two rows 204. The hot aisle 06 provides a contained area for hot exhaust air from the computer systems 202. Cold air enters the computer systems 202 from the front, passes through the computing equipment where heat is absorbed, and exits as hot exhaust air into the hot aisle 06. The containment of the hot aisle 06 prevents mixing of hot exhaust air with the cold supply air, improving cooling efficiency.

In alternative configurations, the rows 204 comprise single rows 204, with each single row 204 having a contained hot aisle 06 associated with only that single row 204. The sub-hall 102a, 102b may also comprise a combination of pairs of rows 204 with contained hot aisles 206 between them and single rows 204 with contained hot aisles 206 associated with only the single row 204.

A plurality of air circulation units 208 are positioned along one side of the sub-hall 102a, 102b. The air circulation units 208 are configured to provide cooling to the computer systems 202 within the sub-hall 102a, 102b. For example, the air circulation units 208 may take the form of prefabricated service modules.

The cooling corridor 126 is located at one end of the sub-hall 102a, 102b. The columns 128 are arranged at regular intervals throughout the structure. External wall panels 130 form the perimeter walls of the sub-hall 102a, 102b.

The modular cooling units 106 described above in relation to FIG. 1 and FIG. 2 may be configured to provide different types of cooling depending on the requirements of the computing equipment installed. The modular cooling units 106 may be dry cooling units that provide air cooling only, distributed chilled liquid cooling units that provide liquid cooling only, or a hybrid comprising both dry cooling units and distributed chilled liquid cooling units. The modular cooling units 106 may be chillers.

In the hybrid configuration, the modular cooling units 106 provide hybrid cooling comprising both air cooling and liquid cooling to the rack or to the chip level. The hybrid cooling system enables variable apportionment between air cooling and water cooling streams. Cooling water in the hybrid cooling system is split into two streams. A first stream provides air cooling via CRAC units (Computer Room Air Conditioning units), where chilled water is supplied to the CRAC units which then cool the air within the sub-hall 102a, 102b. A second stream provides direct water cooling to computer racks within the computer systems 202, bypassing the air cooling pathway and delivering cooling directly to the heat-generating components.

The hybrid cooling approach provides flexibility to accommodate different computing equipment with varying cooling requirements. Traditional air-cooled computing equipment receives cooling via the first stream through the CRAC units, while high-density computing equipment such as that used for artificial intelligence workloads receives direct liquid cooling via the second stream. The apportionment between the two streams is variable, enabling the cooling system to be configured according to the specific mix of computing equipment installed within the sub-hall 102a, 102b. In some cases, the modular cooling units 106 may be configured to provide only air cooling or only liquid cooling, depending on the specific requirements of the computing equipment and the preferences of the data centre operator.

Each row 204 is configured to comprise computer systems 202 with a specified power capacity. The row power capacity may be configured at 250 kW, 375 kW, or 750 kW average power per row 204, for example, to accommodate different computing densities. The 250 kW configuration accommodates traditional computing workloads with moderate power densities. The 375 kW and 750 kW configurations accommodate higher-density computing workloads including artificial intelligence workloads that require greater power and cooling capacity per unit of floor space.

Each row 204 may also have a maximum power requirement, such as 300 kW for a 250 kW average power row. The maximum power requirement represents the peak instantaneous power draw that the row 204 is designed to accommodate, accounting for transient load spikes that may occur during operation. The distinction between average power and maximum power is significant for the design of power distribution infrastructure, as the electrical systems must be sized to handle peak loads even though the average power consumption may be lower. The 300 kW maximum power requirement ensures that the power distribution units 510 and static transfer switches 512 serving each row 204 have sufficient capacity to handle peak demand without tripping protective devices or causing voltage drops that could affect computing equipment operation.

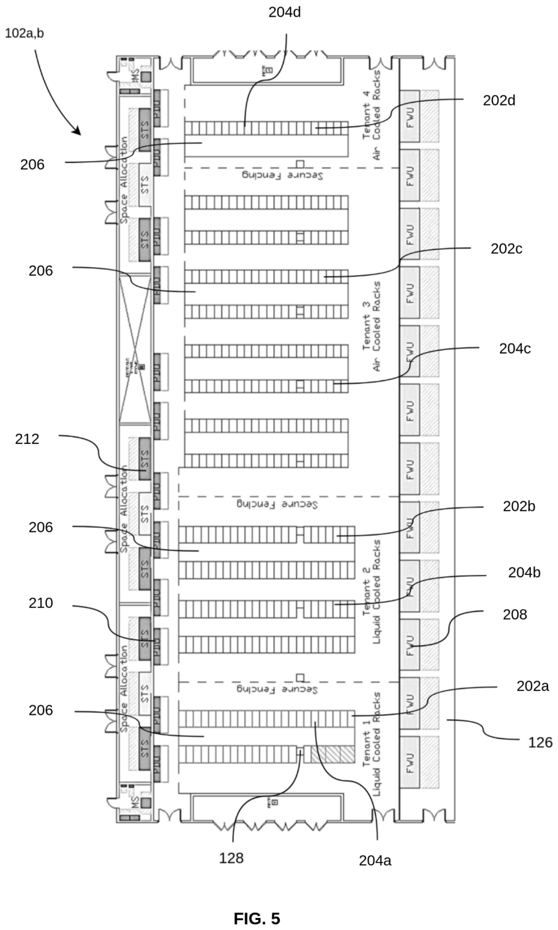

FIG. 5 illustrates a floor plan view of a sub-hall 102a, 102b of the modular data centre 100 showing the arrangement for multiple tenant areas. In the illustrated example, he sub-hall 102a, 102b is divided into four tenant areas separated by secure fencing and separate access controls, ensuring each tenant has access only to their area. Each tenant area is configured to house computer systems with specific cooling requirements, though other combinations of tenant area and cooling systems, in particular the implementation of hybrid air and water cooling systems as described above, are envisaged.

A first tenant area contains a plurality of computer systems 202a arranged in rows 204a. The computer systems 202a are liquid cooled racks configured to receive direct liquid cooling to the computing components within the racks. A second tenant area contains a plurality of computer systems 202b arranged in rows 204b. The computer systems 202b are also liquid cooled racks configured to receive direct liquid cooling. A third tenant area contains a plurality of computer systems 202c arranged in rows 204c. The computer systems 202c are air cooled racks configured to receive cooling via conditioned air supplied to the sub-hall 102a, 102b. A fourth tenant area contains a plurality of computer systems 202d arranged in rows 204d. The computer systems 202d are also air cooled racks configured to receive cooling via conditioned air.

The hot aisles 206 are positioned between pairs of rows 204a, 204b, 204c, 204d throughout the sub-hall 102a, 102b. The hot aisles 206 provide contained areas for hot exhaust air from the computer systems 202a, 202b, 202c, 202d.

A row of power supply equipment is positioned along one edge of the sub-hall 102a, 102b adjacent to the service corridor 124. Each power supply module 104 is associated with power supply equipment comprising a static transfer switch 212 and a power distribution unit 10. The static transfer switches 512 are positioned along the back wall of the service corridor 124. The power distribution units 510 are positioned adjacent to the static transfer switches 512.

The static transfer switches 512 provide automatic transfer capability between primary and reserve power supplies. Each static transfer switch 212 is configured to monitor the incoming power supply and automatically transfer to an alternative power source if the primary supply fails or falls outside acceptable voltage or frequency parameters. The transfer time of the static transfer switches 512 is sufficiently rapid to prevent interruption to the computer systems 202a, 202b, 202c, 202d, typically completing the transfer within milliseconds. This rapid transfer capability ensures continuous operation of the computing equipment during power supply transitions.

The power distribution units 510 are configured to distribute electrical power from the static transfer switches 512 to the individual computer systems 202a, 202b, 202c, 202d within each row 204a, 204b, 204c, 204d. Each power distribution unit 10 includes circuit breakers and monitoring equipment to protect the downstream computing equipment and provide visibility of power consumption at the row level. The power distribution units 510 are sized to accommodate the maximum power requirement of the associated row 204a, 204b, 204c, 204d, ensuring sufficient capacity for peak load conditions.

A power supply module 104, as illustrated in FIGs. 1, 2 and 6, is configured to receive power from both a generator and a utility grid supply. The generator serves as a backup power source rather than the primary power source. The power supply module 104 includes a transformer for receiving utility grid power in addition to the generator power supply. This configuration enables the modular data centre 100 to operate primarily from utility grid power whilst maintaining backup generation capacity for use during grid outages or maintenance periods.

Each power supply module 104 provides two separate power distribution streams. A first power distribution stream is dedicated to IT load and is ring-fenced at a particular power value, such as 1.5 MW. A second power distribution stream is dedicated to building services and mechanical equipment and provides the remaining power that can be generated by the generator, which would be approximately 0.9 MW if the generator is a 2.4 MW generator and the IT power output is 1.5 MW. The separation of IT load from building services load enables independent management of power allocation and ensures that building services equipment does not draw power from the IT allocation.

The generator within each power supply module 104 may have a variety of power outputs, such as 2.4 MW, 3 MW, or 4 MW, depending on the capacity requirements of the associated portion of the data hall 102 and the availability of different generators. For a 3 MW generator with a 1.5 MW IT power allocation, the remaining 1.5 MW would be available for building services and mechanical equipment. For a 4 MW generator with a 1.5 MW IT power allocation, the remaining 2.5 MW would be available for building services and mechanical equipment. Alternatively, larger generators may be paired with higher IT power allocations, such as a 4 MW generator providing 2.5 MW of IT power and 1.5 MW for building services.

The air circulation units 208 are positioned along the opposite edge of the sub-hall 102a, 102b from the power supply equipment, in the cooling corridor 126. The columns 128 are arranged at regular intervals throughout the structure according to the first common spacing α in a length direction (between the top and bottom of the page) and the second common spacing β in a width direction (between the left and right edges of the page) described above in relation to FIG. 3.

### Power Supply Modules

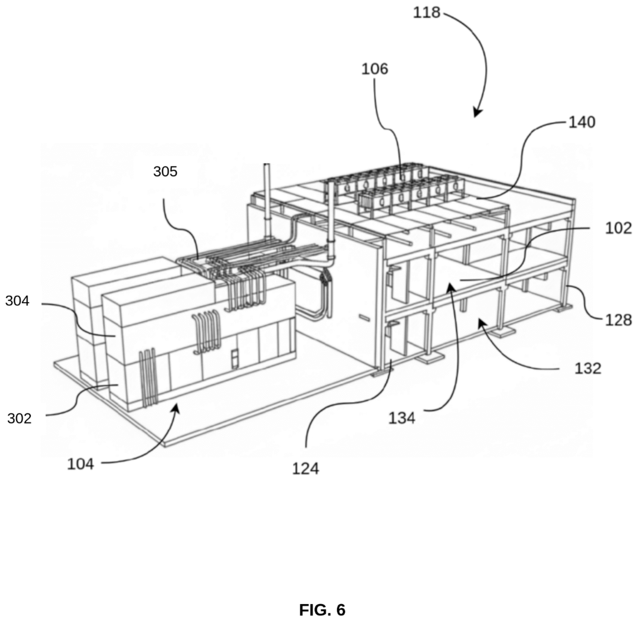

FIG. 6 illustrates an isometric view of a power supply module 104 arrangement showing the structural configuration and component layout adjacent to a middle portion 118 of the data hall 102. The figure illustrates two power supply modules 104 adjacent to the middle portion 118. In some configurations, each portion may have two power supply modules 104 associated with it, where one power supply module 104 provides the primary power supply for the portion and the other power supply module 104 may provide a redundancy power supply. In other configurations, each portion may have a single power supply module 104 associated with it, with one or more additional redundancy power supply modules shared between multiple portions. The exemplary power supply module 104 comprises a stacked container arrangement with multiple distinct sections configured to provide electrical power to the associated middle portion 118 of the data hall 102.

A generator enclosure 302 is positioned at the lower level, forming the base of the stacked arrangement. The generator enclosure 302 houses a generator configured to provide backup power to the data hall 102. The generator enclosure 302 can include acoustic louvres for inlet and outlet air attenuation, reducing noise emissions from the generator during operation. The generator enclosure 302 may include a belly tank fuel storage integrated within the enclosure frame, for example providing up to 48 hours of fuel storage, enabling extended operation during utility grid outages without requiring external fuel delivery.

An electrical pod 304 is positioned above the generator enclosure 302. The electrical pod 304 houses electrical distribution equipment configured to receive power from both the generator enclosure 302 and a utility grid supply, and distribute the power to the data hall 102. The electrical pod 304 includes a transformer for receiving utility grid power, enabling the modular data centre 100 to operate primarily from utility grid power whilst maintaining backup generation capacity from the generator enclosure 302 for use during grid outages or maintenance periods. The electrical pod 304 and the generator pod 304 are designed to be manufacturer-agnostic, capable of accommodating equipment from multiple manufacturers including Schneider, Eaton, and MTU. This manufacturer-agnostic design enables procurement flexibility and avoids dependency on a single equipment supplier.

The electrical pod 304 houses all of the electrical components for providing power to the respective portion that it is associated with, including the IT power required by that portion and ancillary power, such as for cooling. The electrical components include battery and medium voltage (MV) equipment, low voltage (LV) equipment and a transformer, and uninterruptible power supply (UPS) equipment.

Cable routing infrastructure 305 connects the power supply module 104 to the data hall 102. The cable routing infrastructure 305 extends from the electrical pod 304 across the gap between the power supply module 104 and the data hall 102, entering the data hall 102 through the service corridor 124. The cable routing infrastructure 305 carries electrical power cables and control cables between the power supply module 104 and the electrical distribution equipment within the service corridor 124.The electrical power from the power supply module 104 is used to power IT equipment contained within the data hall, and plant equipment in the data hall such as the modular cooling units 106. Such plant equipment may also be referred to as building services equipment herein, and relates to any equipment other than the IT equipment, such as heating/cooling systems, ventilation systems lighting, security systems, and other mechanical plant equipment that supports the operation of the data centre.

The power supply module 104 is designed as a modular, standardised unit that can be manufactured in volume and deployed across multiple data centre installations. This can significantly increase the speed of constructing data centres compared to conventional bespoke power infrastructure installations, as well as enabling scalability for data centre operators. Each power supply module 104 may have identical specifications and configurations, enabling mass production efficiencies that reduce per-unit manufacturing costs compared to bespoke power supply installations designed individually for each data centre project. The standardisation of power supply modules 104 also simplifies procurement, as identical units can be ordered in varying quantities depending on the required data centre capacity, and enables the establishment of supply chain relationships with manufacturers who can produce these units at scale.

The power supply module 104 dimensions may be designed to approximate standard shipping container dimensions of approximately 2.4 metres wide by 12.2 metres long. These dimensions enable ease of transport using standard transportation equipment, including via rail and road. For example, the power supply module 104 may configured to be transported on a standard flatbed lorry without requiring convoy arrangements, simplifying logistics and reducing transportation costs. The container-like dimensions also enable the power supply modules 104 to be manufactured off-site in a controlled factory environment and delivered to site fully assembled and pre-tested, reducing on-site installation time and ensuring consistent quality across all units. This approach eliminates the need for extensive on-site installation work that would typically be required for traditional power supply infrastructure, enabling faster deployment timelines and reducing reliance on skilled on-site labour, while improving site safety.

The modular and standardised nature of the power supply modules 104 provides additional benefits for maintenance and replacement operations. Because each power supply module 104 may be identical, spare parts and replacement components can be stocked efficiently, and maintenance personnel become proficient in servicing a single standardised configuration rather than multiple bespoke installations. In the event of a failure, an entire power supply module 104 can be replaced with a pre-manufactured unit, minimising or even eliminating downtime compared to traditional power infrastructure where repairs must be conducted in situ.

The service corridor 124 is visible between the power supply module 104 and the data hall 102. The data hall 102 structure includes columns 128 arranged in a regular grid pattern, with a ground floor 132 and a first floor 134 visible in the embodiment of FIG. 6. The modular cooling units 106 are mounted on the roof of the data hall 102, supported by a cooling unit platform 140 .

The positioning of the service corridor 124 adjacent to the power supply modules 104 is configured to minimise the length of cable runs between the power supply modules 104 and the electrical distribution equipment within the data hall 102. Shorter cable lengths reduce electrical losses due to resistance in the conductors, improving overall power distribution efficiency. The reduced cable lengths also decrease the quantity of cabling material required, reducing both material costs and installation time. Furthermore, shorter cable runs simplify cable management and reduce the complexity of cable routing, making installation and future maintenance operations more straightforward. The proximity of the service corridor 124 to the power supply modules 104 also facilitates fault diagnosis and repair, as the electrical infrastructure connecting the power supply modules 104 to the data hall 102 is concentrated in an accessible location rather than being distributed throughout the facility.

The middle portion 118 illustrated in FIG. 6 demonstrates the repeatable unit configuration of the data hall 102. The middle portion 118 comprises a section of the data hall 102 with associated power supply module 104, modular cooling units 106, and service corridor 124 infrastructure. Additional middle portions 118 are added to extend the data hall 102 by replicating the configuration illustrated in FIG. 6. Because each portion (first end portion 114, second end portion 116, and middle portions 118) has its own associated power supply module 104, the power capacity of the modular data centre 100 scales proportionally with the size of the data hall 102. When additional middle portions 118 are added to extend the data hall 102, each additional middle portion 118 brings its own power supply module 104, ensuring that power capacity automatically scales with the data hall 102 size. This eliminates the need for complex recalculations of power infrastructure when adjusting data centre capacity, as the power requirements are predetermined and factored into the design of each portion.

The middle portion 118 is converted into an end portion 114, 116 or an intermediate portion 120, 122 by varying the precast components used in construction. End portions 114, 116 include external wall panels 130 at the end of the data hall 102, while middle portions 118 positioned between other portions do not require external wall panels 130 at the boundaries with adjacent portions. Intermediate portions 120, 122 include partition walls or fire separation elements at the boundary between the first sub-hall 102a and the second sub-hall 102b. By selecting the appropriate precast components for each position, the same basic portion configuration is adapted to serve as a first end portion 114, a second end portion 116, a middle portion 118, a first intermediate portion 120, or a second intermediate portion 122.

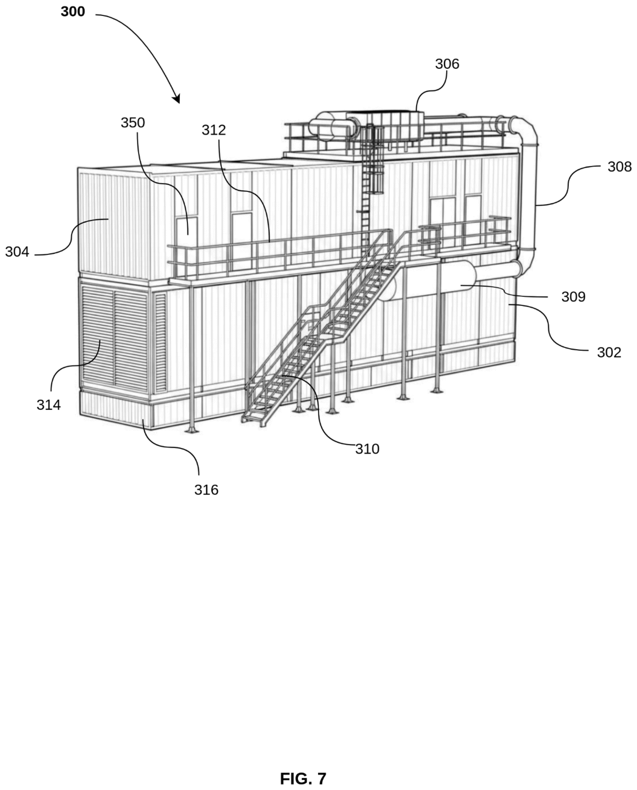

FIG. 7 illustrates an isometric view of a power supply module 300, which may be used as the power supply module 104 of FIGs. 1, 2 and 6. In general, the power supply modules 104 and 300 may be referred to as combined generator and electrical modules or containerized generator and electrical modules. The power supply module 300 has a stacked container arrangement. The power supply module 300 includes a first container 302 positioned at a lower level forming the base of the stacked arrangement, and a second container 304 positioned above the first container 302. The first container 302 may also be referred to as a generator enclosure herein, and the second container 304 may also be referred to as an electrical enclosure or electrical pod herein. The first container 302 includes a base and sidewalls that enclose a first volume. The second container 304 includes a base and sidewalls that enclose a second volume. The second container 304 is configured to be stacked above the first container 302 with the base of the second container 304 supported by the first container 302. In this arrangement, the power supply module 300 is a modular assembly, wherein the first container 302 forms a first storey of the modular assembly, and the second container 304 forms a second storey of the modular assembly.

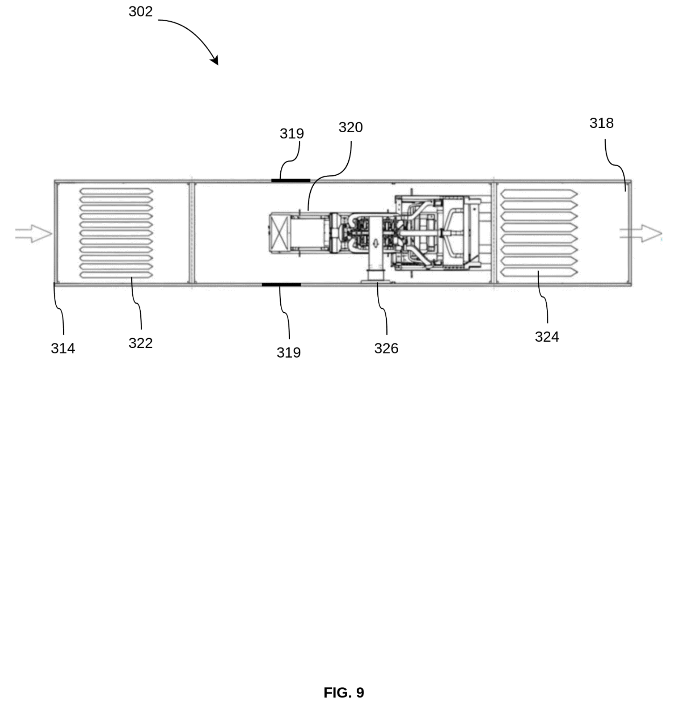

The first container 302 houses a generator unit within the first volume. The generator unit is configured to provide backup power to the modular data centre 100 when power from an external power supply, such as a utility or grid connection, fails. The first container 302 includes an air inlet having built in acoustic attenuation via a first acoustic louvre 314 at a first end of the power supply module 300, to act as an air inlet part of an air intake system as will be discussed in more detail in relation to FIG. 9.

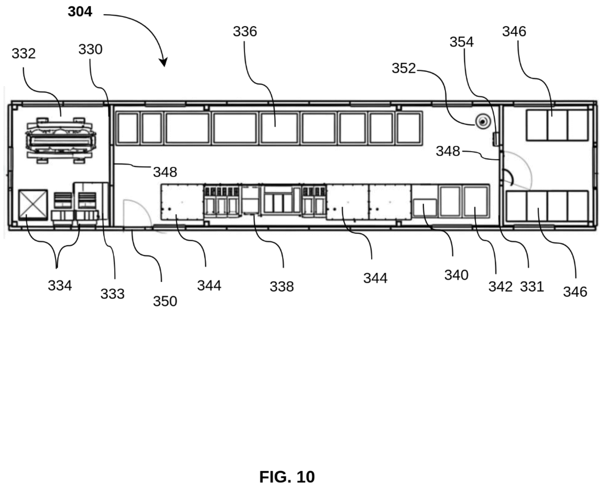

The second container 304 houses one or more electrical units within the second volume. The one or more electrical units are configured to receive power from an external power supply or from the generator unit and output the received power to the data hall 102 of the modular data centre 100, as will be discussed in more detail in relation to FIG. 10.

The base of the first container 302 and the base of the second container 304 have the same footprint. This matching footprint configuration provides a uniform vertical profile for the power supply module 300, with the second container 304 aligning directly above the first container 302 without overhang or offset. The aligned footprints facilitate structural support between the containers, as the load from the second container 304 is transferred directly through the structural frame of the first container 302 to the ground below. This configuration also enables efficient use of the available ground area and simplifies the stacking process during installation.

In general, the size of the container footprint may be any suitable size to enable the containers to house the generator unit / one or more electrical units. In some embodiments, the power supply module 300 footprint dimensions may be between approximately 2 to 10 meters wide by 10 to 20 meters long, preferably approximately 3.8 metres wide by 17.3 metres long, or approximately 3.8 metres wide by 21 metres long. In other embodiments, the power supply module 300 footprint dimensions are designed to approximate standard shipping container dimensions of roughly 2.4 metres wide by 12.2 metres long, to enable ease of transport using standard transportation equipment, including via rail and road.

As shown in FIG. 7, a fuel module 316 may be positioned beneath the first container 302. The fuel module 316 is configured to receive the first container 302 with the base of the first container 302 supported by the fuel module 316. The fuel module 316 provides a space for a fuel tank beneath the first container 302, as will be discussed in more detail later. The fuel module 316 may elevate the first container 302 above ground level, for example by up to 1 meter in some embodiments. In some embodiments, the fuel module 316 may be a separate component to the first container 302. In other embodiments, the fuel module 316 may be integral with the first container 302. Alternatively, in some embodiments the fuel module may be omitted altogether, with the base of the first container 302 positioned directly on the ground.

An exhaust unit 306 is disposed on a roof of the second container 304. The exhaust unit 306 is coupled to an exhaust outlet of the generator unit via an exhaust duct 308 that extends from the first container 302 and around the outside of the second container 304. The exhaust unit 306 may comprise a selective catalytic reduction (SCR) system or the like, to function as a catalytic converter for environmental cleanup of exhaust emissions from the generator unit. An exhaust silencer 309 may also be positioned along the exhaust duct 308 in some embodiments, to reduce noise from the generator exhaust system.

In some embodiments, the combined weight of the second container 304 and the exhaust unit 306 may be in excess of 53 to 55 tonnes. This substantial weight imposes significant structural requirements on the first container 302, which must be sufficiently robust to support the entire load of the second container 304 and its contents when stacked. The first container 302 may therefore be constructed with a reinforced structural frame, including strengthened corner posts and load-bearing members, designed to transfer the weight of the second container 304 to the fuel module 316 and/or ground foundation.

As shown in FIG. 7, the second container 304 may also include an external door 350 on one sidewall, providing access to the interior of the second container 304 for maintenance and servicing of the electrical units housed within. In the embodiment of FIG. 7, a staircase 310 extends along an outside wall of the first container 302, providing access into the second container 304 via the external door 350. Other access means such as ladders or the like may also be used. A walkway platform 312 with safety railings may be included around portions of the second container 304 at the upper level, facilitating maintenance access to the electrical equipment housed within the second container 304 and access to the exhaust unit 306 on the roof.

The first container 302 and the second container 304 may be constructed from metal or other suitable structural materials. The sidewalls of the containers may comprise steel panels or the like, which may be corrugated or ribbed to provide structural rigidity while minimising material weight. The steel panels may be galvanised or otherwise treated to provide corrosion resistance for outdoor installation. The structural frames of the containers, including corner posts, floor beams, and roof beams, may be constructed from structural steel sections sized to accommodate the loads imposed during transport, lifting, and stacking operations.

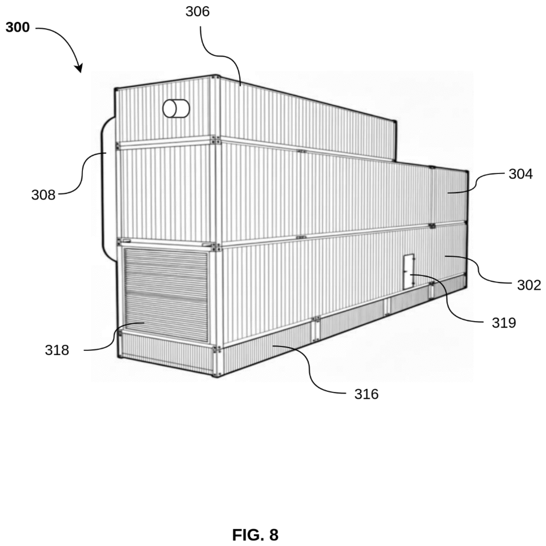

FIG. 8 illustrates a rear isometric view of the power supply module 300 of FIG. 7, viewed from the reverse direction.

An air outlet having a built in second acoustic louvre 318 is visible at a second end of the power supply module 300 in FIG. 8, forming part of an air discharge system to expel air from within the first container 302, as will be discussed in more detail in relation to FIG. 9.

The view in FIG. 8 further includes a cover over the exhaust unit 306 that encloses the components of the exhaust unit 306, such as the SCR system. Such a cover configuration is optional, and may be included to provide weather protection for the exhaust unit 306 and present a uniform external appearance for the power supply module 300 (as shown in FIGs. 6 and 8). In other embodiments, the cover may be omitted, as shown in FIG. 7.

An external door 319 may also be included on a sidewall of the first container 302, providing access to the interior of the first container 302 for maintenance and servicing of the generator unit.

FIG. 9 illustrates a plan view of the first container 302 showing the internal arrangement and layout of components within the first container 302 (generator enclosure).

The first container 302 comprises a first compartment, a second compartment and a third compartment arranged linearly along the length of the first container 302. The first compartment is located at a first end of the first container 302. The third compartment is located at a second end of the first container 302 opposing the first end. The second compartment is located between the first compartment and the third compartment.

The first compartment comprises an air intake system configured to draw air into the first container 302 (shown by the arrow on the left hand side of FIG. 9) for cooling a generator unit 320 within the first container. The air intake system may include an inlet ventilation attenuator 322 positioned within the first compartment. The inlet ventilation attenuator 322 is configured to attenuate noise from air entering the first container 302. The first acoustic louvre 314 is positioned at the end wall of the first container 302 adjacent to the inlet ventilation attenuator 322. The first compartment includes the first acoustic louvre 314 passing through a first end wall of the first container 302, providing an air intake opening through which cooling air is drawn into the first container 302. Air can then flow from the first compartment into the second compartment.

The second compartment contains the generator unit 320, and will also be referred to as a generator compartment herein. The generator unit 320 is positioned within the second compartment and is configured to provide backup power to the modular data centre 100, e.g. during failure of an external grid-based power supply. In some embodiments, the generator unit 320 may provide a power between 1.5MW and 10MW, preferably between 2MW and 5MW. In a specific embodiment, the generator unit 320 is a 2.4MW generator. The 2.4MW generator configuration is particularly beneficial because generators of this capacity are readily available, cost-effective, and mass produced. Further, a 2.4MW generator provides sufficient capacity to supply the 1.5MW of IT equipment power required by the associated portion of the data hall (the first power supply stream), together with an additional power (0.9MW in this embodiment) for powering plant equipment (i.e. equipment other than the IT equipment) such as cooling systems, lighting, and other mechanical infrastructure supporting the data centre operation (the second power supply stream).

The generator unit 302 may include both an engine portion and an electrical generator portion. Further, the generator unit may also include one or more radiator portions to help remove heat from the engine portion of the generator unit.

In some embodiments, the generator unit 320 may be mounted on dampers or the like for vibration attenuation and isolation. Such dampers attenuate vibrations generated during operation of the generator unit 320, reducing transmission of vibrations to the first container 302 and the surrounding structure of the power supply module 300.

In some embodiments, the second compartment of the first container 302 may further include a fuel tank to provide fuel for the generator unit 320 (not shown in FIG. 9). Alternatively, the fuel tank for the generator unit may be located elsewhere. For example, in some embodiments the fuel tank may be positioned within the fuel module 316 beneath the first container 302. Such a fuel tank may be referred to as a belly tank due to its location at the underside of the first container 302. Thus fuel module 316 supports the base of the first container 302 whilst simultaneously housing the fuel tank 358 within the structural framework. This integrated arrangement positions the fuel tank 358 directly beneath the generator unit 320, minimising the length of fuel supply lines between the fuel tank 358 and the generator unit 320, whilst advantageously storing the large weight of fuel required at the lowest level of the power supply module 300. In some embodiments, such a fuel tank 358 may be configured to provide up to 48 hours of fuel storage, enabling extended operation during utility grid outages without requiring external fuel delivery.

In other embodiments, the fuel tank may be a separate external above or below ground tank located away from (e.g. remote from) the power supply module 300. Such a fuel tank configuration may be advantageous where larger fuel storage capacity is required. Moreover, a larger separate external tank may be used to provide fuel to multiple power supply modules 300 in some embodiments, enabling a centralised fuel storage arrangement that serves multiple generator units across the modular data centre 100.

As shown in FIG. 9, an exhaust outlet 326 extends from the generator unit 320. The exhaust outlet 326 is configured to route exhaust gases from the generator unit 320 out of the first container 302. The exhaust outlet 326 may be connected to the exhaust unit 306 positioned above the second container 304 via exhaust duct 308, as described previously in relation to FIG. 7.

The third compartment of the first container 302 comprises an air discharge system configured to expel from the first container 302 the cooling air that has since been heated by the generator unit 320 (shown by the arrow on the right hand side of FIG. 9). In other words, heated air from the second compartment can flow into the third compartment. The air discharge system may include a discharge ventilation attenuator 324 positioned within the third compartment. The discharge ventilation attenuator 324 is configured to attenuate noise from air exiting the first container 302 after cooling the generator unit 320. The second acoustic louvre 318 is positioned at the end wall of the first container 302 adjacent to the discharge ventilation attenuator 324. The third compartment includes the second acoustic louvre 318 passing through a second end wall of the first container 302, providing an air discharge opening through which heated air is expelled from the first container 302.

In the embodiment of FIG. 9, the linear arrangement of the air intake system, the generator unit 320, and the air discharge system establishes an airflow path through the first container 302. Cooling air enters through the first acoustic louvre 314, passes over the engine portion and/or one or more radiator portions of the generator unit 320 to absorb heat, and exits through the second acoustic louvre 318. In general, the components of the air intake and air discharge systems may be located anywhere within the first container 302 provided that they create an airflow past the engine and/or one or more radiator portions of the generator unit 320. For example, in some embodiments the acoustic louvres 314 and 318 may be positioned at other locations within the sidewalls of the first container 302, rather than at the end walls of the first container 302.

In some embodiments, the one or more radiator portions may be positioned on the generator unit 320 directly adjacent to the air discharge system of the third compartment. Further, in some embodiments a sealing means could be provided around the one or more radiator portions of the generator unit 320, to ensure cooling air flows past the one or more radiator portions before entering the air discharge system of the third compartment.

As shown in FIG. 9, in some embodiments the first container 302 may include one or more external doors 319 through the sidewalls of the first container 302, providing access to the interior of the first container 302 for maintenance and servicing of the generator unit 320.

In some embodiments, the first container 302 may be formed from a plurality of container sections that couple together to form the first container 302. The container sections may be configured in various arrangements depending on manufacturing and transport requirements.

In one configuration, as shown in FIG. 9, the plurality of container sections correspond to the compartments of the first container 302. In this arrangement, a first container section houses the first compartment containing the inlet ventilation attenuator 322, a second container section houses the second compartment containing the generator unit 320, and a third container section houses the third compartment containing the discharge ventilation attenuator 324.

In an alternative configuration, the container sections are independent of the compartment arrangement. For example, the first container 302 may be formed from two container sections of equal length that couple together at a central location. This configuration provides flexibility in the sizing and positioning of the air intake compartment, generator compartment, and air discharge compartment independently of the structural divisions between container sections.

In some embodiments, once the container sections are coupled together to form the first container 302, the components within the first container 302 (such as the inlet ventilation attenuator 322, generator unit 320, and discharge ventilation attenuator 324) can be installed into or removed from the first container 302 via the end walls of the first container 302. For example, the first acoustic louvre 314 and/or and second acoustic louvre 318 may be removable to enable any of the components within the first container 302 to be removed, e.g. for maintenance.

FIG. 10 illustrates a floor plan view of the second container 304 showing an internal arrangement and layout of electrical components within the second container 304 (electrical pod) in a specific embodiment of the invention.

The second container 304 houses electrical distribution equipment configured to receive power from both the generator unit 320 housed within the first container 302 and a utility/grid supply, and distribute the power to the data hall 102. The second container 304 operates primarily from utility grid power whilst maintaining backup generation capacity from the generator unit 320 for use during grid outages or maintenance periods or the like. The second container 304 houses all of the electrical components for providing power to the respective portion of the data hall 102 that it is associated with, including the IT power required by that portion and ancillary (plant) power, such as for cooling.

In some embodiments, the second container 304 may include one or more internal walls to partition the second volume into a plurality of compartments. For example, in the embodiment of FIG. 10 the second container 304 is divided into three compartments by a first internal wall 330 and a second internal wall 331. Each compartment can be configured to house different electrical units, depending on the specific configuration of the electrical pod. In general, any number and layout of internal compartments may be used. Further in some embodiments internal walls may be omitted, such that the second container 304 has only one compartment (the second volume).

The embodiment of FIG. 10 includes a first compartment, a second compartment, and a third compartment. The third compartment is located at one end of the second container 304 and contains a transformer 332. The transformer 332 is configured for voltage conversion, receiving power from an external power supply such as a utility grid connection and converting the voltage to levels suitable for distribution within the modular data centre 100. For example, the transformer 332 may be a step down transformer, converting the high voltage external power supply to a lower voltage level before being passed to other electrical units within the second container 304. The third compartment further includes a ring main unit (RMU) 333 to facilitate the delivery of high voltage power from the external power supply to the transformer. Extraction fan equipment 334 may also be included in the first compartment to provide ventilation for the transformer compartment, removing heat generated by the transformer 332 during operation.

The first internal wall 330 separates the third compartment containing the transformer 332 from the second compartment. The second compartment forms the central electrical distribution area of the second container 304. In the specific embodiment shown in FIG. 10, a main switchboard 336 (first switchboard) is positioned within the second compartment and is configured to receive electrical power from the transformer 332 or receive power from the generator unit 320, and distribute the power downstream to IT equipment within the data hall 102 (in the first power supply stream). A second switchboard 342 is positioned within the second compartment and is configured to receive electrical power from the transformer 332 or receive power from the generator unit 320, and distribute the power to downstream to mechanical plant equipment within the data centre (in the second power supply stream). A first UPS 338 and a second UPS 340 are positioned in the second compartment to provide uninterruptible power supply to the data hall 102 in the event of a disruption to the external power supply. For example, the first UPS 338 and the second UPS 340 are configured to maintain continuous power supply during a failure of the external power supply, by providing power either until a transition between the external power supply and the generator unit 320 has completed, or until the external power supply is restored. Thus, the first UPS 338 and the second UPS 340 prevent interruption to the power supply for the computer systems or plant equipment within the data hall 102. The first UPS 338 may be associated with the main switchboard 336 to prevent a disruption in the power supplied to the IT equipment. The second UPS 340 may be associated with the second switchboard 342 to prevent a disruption in the power supplied to the plant equipment. In general, either of the first UPS 338 and second UPS 340 may include more than one UPS system.

The second internal wall 331 separates the second compartment from the first compartment. The first compartment is located at the opposite end of the second container 304 from the third compartment in the embodiment of FIG. 10. However as discussed, any suitable layout of compartments may be used within the second container 304. The first compartment contains one or more batteries 346. The batteries 346 provide backup power during transitions between the external power supply and the generator unit 320, e.g. during a failure of the external power supply.

The internal walls 330 and 331 may comprise an internal fire separation layer comprising a fire-retardant material, providing fire protection between the compartments within the second container 304. Such internal fire separation is particularly important for separating the battery compartment from other electrical equipment due to the fire risks associated with battery systems, particularly lithium-ion batteries which can present thermal runaway risks. By housing the batteries 346 in a dedicated compartment separated from other electrical units by fire-retardant internal walls, the risk of fire propagation from a battery incident to other critical electrical equipment can be reduced. Similarly, the fire separation protects the batteries 346 from fire events originating in other compartments of the second container 304, such as electrical faults in the switchboards or transformer.

The internal fire separation layer may be configured to provide a specific fire rating, such as a 1 hour, 2 hour, or 4 hour fire rating, depending on local fire regulations and the specific requirements of the data centre installation. The fire rating determines the duration for which the internal walls can maintain their structural integrity and prevent fire spread between compartments, providing time for fire suppression systems to activate and for firefighting teams to respond to a fire event.

In the embodiment of FIG. 10, computer room air handler (CRAH) units 344 are positioned along the length of the second compartment to provide cooling for the electrical equipment housed within. The CRAH units 344 maintain appropriate operating temperatures for the main switchboard 336, the first UPS 338, the second UPS 340, the second switchboard 342. In general, other such cooling units may be included in any compartment of the second container 302 as required.

As shown in FIG. 10, internal doors 348 may be included in the internal walls to provide access between compartments within the second container 304, e.g. for maintenance and operation. One or more external doors 350 may also be included to provide access to the second container 304 from outside (one specific layout of multiple external doors is shown in FIG. 7).

In some embodiments, specific fire safety equipment may be distributed throughout the second container 304. For example, in FIG. 10 fire suppression equipment 352 is provided within the second container 304 to protect the container in the event of a fire. The fire suppression equipment 352 may comprise automatic suppression systems configured to detect and suppress fires within the electrical compartments of the second container 304. Further, a fire alarm panel 354 monitors fire detection systems and provides alarm and control functions for fire safety within the second container 304.

The one or more electrical units within the second container 304 are configured to output a first power supply stream for IT equipment of the modular data centre 100, using power provided by either the external power supply (e.g. via the transformer) or the generator unit. In some embodiments, the first power supply stream is output via the main switchboard 336 (first switchboard). The first power supply stream may be output via a plurality of output terminals (included in the main switchboard 336), wherein each of the plurality of output terminals may be associated with a respective portion of IT equipment of the modular data centre 100, e.g. different IT equipment racks. In some embodiments, the first power supply stream is equal to 1.5MW.

Further, the one or more electrical units within the second container 304 may be further configured to output a second power supply stream for plant equipment of the modular data centre 100. In some embodiments, the second power supply stream is output via the second switchboard 342. The second power supply stream provides power for heating/cooling systems, ventilation systems, lighting, and other mechanical infrastructure supporting the data centre operation. In some embodiments, the second power supply stream is equal to 0.9MW.

It is noted that although one specific arrangement of electrical units and one specific power distribution scheme has been described above in relation to FIG. 10, various other arrangements of electrical units may be housed in the second container 304 in other embodiments.

The stacked configuration of the power supply module 300, with the second container 304 positioned above the first container 302, provides advantageous alignment with the electrical distribution infrastructure within the data hall 102. In typical data centre configurations, power distribution equipment and cabling are routed along the ceiling of the data hall, for example at a height of approximately 6 metres above floor level. By positioning the second container 304 at an elevated level above the first container 302, the electrical outputs from the second container 304 are located at a height that corresponds to the ceiling-level distribution infrastructure within the data hall 102. This alignment reduces the vertical distance that power cables must traverse between the electrical units and the ceiling-mounted distribution equipment within the data centre, simplifying cable routing and reducing cable lengths. Furthermore, in multi-storey data centre configurations, the elevated position of the second container 304 provides a shorter cable path to upper floors of the data hall 102, reducing cable losses and installation complexity when serving IT equipment located on floors above ground level.

In some embodiments, the one or more electrical units within the second container 304 may further include one or more load bank connection terminals. The load bank connection terminals enable connecting of an external load bank to enable testing of the electrical infrastructure within the second container 304. The load bank connection terminals may be located on the outside of the first or second container 304,304 or may be located within the second container 304, with a weatherproof opening provided in the second container 304 to enable cables to pass into the container 304.

In some embodiments, the second container 304 comprises a plurality of container sections that couple together to form the second container 304. The plurality of container sections may correspond to the compartments of the second container 304. In this arrangement, a first container section houses the first compartment containing the batteries 346, a second container section houses the second compartment containing the first UPS 338, the second UPS 340, and the main switchboard 336 etc, and a third container section houses the third compartment containing the transformer 332 and RMU 333. The container sections couple together to form the complete second container 304.

In embodiments where the second container 304 is formed from a plurality of container sections, the one or more internal walls may be formed by the couplings between the plurality of container sections. Specifically, each container section may be provided with the internal walls forming the outer walls of that section, such that when two or more container sections are connected together to form the second container 304, the outer walls of adjacent sections become the internal walls separating the compartments within the assembled second container 304. A layer of fire-retardant material may be positioned between the coupled container sections of the second container 304 to form the internal fire separation layer in the internal walls, providing fire protection between the compartments. This configuration enables the internal fire separation walls to be integrated into the structural connections between container sections, simplifying construction while maintaining fire separation requirements.

In an alternative configuration, the container sections are independent of the internal compartment arrangement. In this arrangement, the second container 304 may be formed from two or more container sections that couple together, with the internal partitioning into compartments being performed after the container sections are coupled together. For example, the second container 304 may be formed from two container sections of equal length having open ends that couple together at a central location, with internal walls subsequently installed to define the first, second and third compartments as described above. This configuration provides flexibility in the sizing and positioning of internal compartments independently of the structural divisions between container sections.

Such sectional construction of the second container 304 is particularly advantageous given the substantial weight of the electrical units housed within which can make transportation of the fully assembled second container 304 challenging or impractical in some circumstances. By constructing the second container 304 from a plurality of container sections that couple together, each individual section can be transported separately with its associated electrical equipment already installed, reducing the weight of each transportable unit to within practical limits for road, rail, or other transportation methods. This sectional approach enables the second container 304 to be shipped in parts to the installation site, where the container sections are coupled together to form the complete second container 304 before or during stacking above the first container 302. Furthermore, the sectional construction allows removal of one section for maintenance without removal of the remaining sections, for example enabling just the third section containing the transformer 332 to be removed and/or replaced whilst the first and second sections remain in position.

In general, the first container 302 (e.g. the embodiment of FIG. 9) and the second container 304 (e.g. the embodiment of FIG. 10) may each be pre-commissioned and pre-tested off-site in a factory environment (whether in sections or as a completed container) before delivery to the installation site. This off-site commissioning approach ensures that the generator unit 320 and the electrical units housed within the containers are functional and verified before arrival at site, reducing the risk of on-site commissioning issues and enabling rapid deployment of the power supply module 300.

### Electrical Topology of Power Distribution System

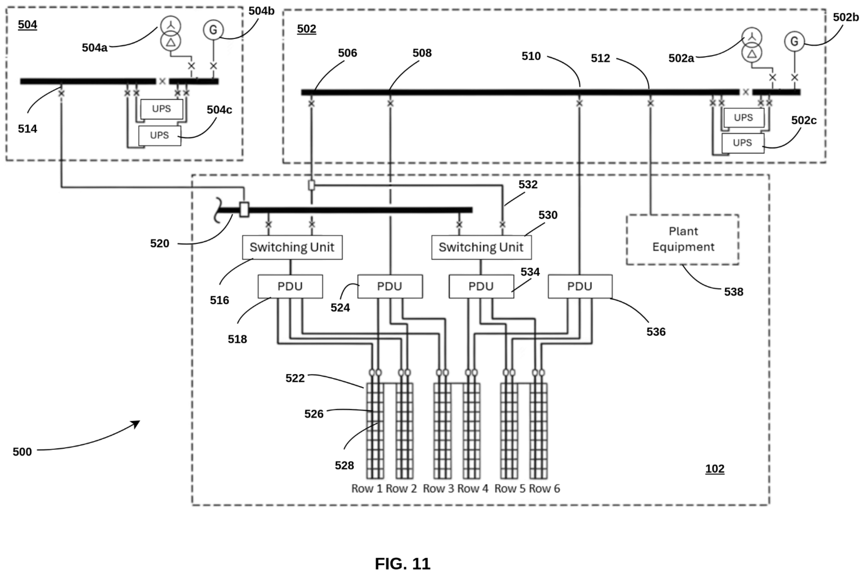

FIG. 11 illustrates a schematic diagram of a power distribution system 500 for the modular data centre 100. The power distribution system 500 is configured to provide electrical power to a data hall 102 such as that in FIGs. 1 to 6, which has the first end portion 114, the second end portion 116, and one or more middle portions 118 arranged in a repeating linear fashion between the first end portion 114 and the second end portion 116 so as to form the data hall 102.

The power distribution system 500 comprises a plurality of power supply modules 502, each associated with a respective portion of the data hall 102. Only one power supply module 502 is shown in FIG. 11 for simplicity, however the power distribution system 500 will include a respective power supply module 502 for each portion of the data hall 102. Each power supply module 502 may be a power supply module 104 and 300 as described in relation to FIGs. 6 to 10.

As described previously, each power supply module 502 includes an external supply input and transformer 502a configured to receive electrical power from an external power supply, such as a utility or grid connection, and convert a voltage of the electrical power received from the external power supply to levels suitable for distribution within the modular data centre 100. The power supply module 502 further includes a generator unit 502b to provide back-up power during a failure of the external power supply. Further, as described previously (in relation to the first UPS 338 and second UPS 340 of FIG. 10), one or more UPS 502c systems are included within the power supply module 502 to provide uninterruptible power supply capability, maintaining continuous power at the output terminals of the power supply module 502 during transitions between the external power supply 502a and the power supply module generator unit 502b.

The power distribution system 500 further comprises a redundancy power supply module 504. The redundancy power supply module 504 includes an external supply input and transformer 504a, a generator unit 504b, and one or more UPS systems 504c, analogous to the power supply module 502 for each portion of the data hall 102. The redundancy power supply module 504 outputs electrical power to provide backup power for some or all plurality of power supply modules 502 supplying the data hall 102.

Specifically, the power distribution system 500 is configured such that a single redundancy power supply module can provide backup power capability for multiple portions of the data hall 102. In particular, one redundancy power supply module may be provided for N portions of the data hall 102, where N is an integer greater than one. This arrangement enables the redundancy power supply module to serve as a shared backup power source for the N power supply modules associated with those N portions of the data hall 102, rather than requiring a dedicated redundancy power supply module for each individual portion of the data hall. For example, in some configurations, one redundancy power supply module may provide backup capability for six portions of the data hall 102 (N=6), such that if any one of the six associated power supply modules 502 were to fail, the redundancy power supply module 504 could supply power to the affected portion. The value of N may be selected based on the redundancy requirements specified by the data centre operator, the power capacity of the redundancy power supply module, and the expected failure rates of the primary power supply modules 502. In some embodiments, the value of N may be between 2 and 20, preferably between 4 and 12, more preferably either 3, 4, 6, 8 or 12. This shared redundancy approach provides significant cost advantages compared to providing a dedicated redundancy power supply module for each portion, as the redundancy infrastructure is shared across multiple portions whilst still maintaining the ability to provide backup power in the event of a failure of any individual power supply module.

In some embodiments, N may include all portions of the data hall 102, such that a single redundancy power supply module 504 provides backup capability for every power supply module 502 within the power distribution system 500. In other embodiments, N may represent only a subset of the total number of portions of the data hall 102, and additional redundancy power supply modules may be provided to serve the remaining portions of the data hall 102. For example, in one embodiment a data centre could include twelve portions, and two redundancy power supply modules may be provided such that each redundancy power supply module serves six of those twelve portions (i.e. N=6 for each of the two redundancy power supply modules). Various other combinations are possible, as would be understood by the skilled person. In general, the total number of potions within the data hall 102 may be divided into groups each containing N portions of the data hall 102, with each group having a respective redundancy power supply module serving the N portions within that group. Further, in some embodiments the number of portions within each group may vary between groups (i.e. the value of N may be different for different redundancy power supply modules).

In FIG. 11, the dotted box labelled 102 delineates the components within the data hall 102. The power supply module 502 and the redundancy power supply module 504 structurally separate from the data hall 102, as discussed above in relation to FIGs. 1, 2 and 6.

Each power supply module 502 comprises a first output terminal 506, and may optionally comprise a second output terminal 508, a third output terminal 510, and an additional output terminal 512 as will be discussed in more detail later. The first output terminal 506, second output terminal 508, and third output terminal 510 are configured to output electrical power for IT equipment within the associated portion of the data hall 102 (i.e. the first power supply stream discussed previously). The additional output terminal 512 is configured to output electrical power to plant equipment 538 within the data centre (i.e. the second power supply stream discussed previously). The redundancy power supply module 504 also comprises an output terminal 514, which is configured to output the electrical power for redundancy purposes.

The power distribution system 500 comprises a plurality of switching units, with each power supply module 502 within the power distribution system 500 having an associated switching unit. Thus, each switching unit is associated with one of the power supply modules 502, and is also therefore associated with the portion of the data hall 102 associated with that power supply module.

As shown in FIG. 11, a switching unit 516 is associated with the power supply module 502. The switching unit 516 comprises a first input terminal configured to receive electrical power from the first output terminal 506 of the power supply module 502. The switching unit 516 further comprises a second input terminal configured to receive electrical power from the redundancy power supply module 504 (i.e. from output terminal 514 of the redundancy power supply module 504 via a redundancy busbar 520, as will be discussed in more detail later). The switching unit 516 further comprises an output terminal configured to output electrical power for one or more computer systems 522 within the associated portion of the data hall 102 (labelled Row 1, Row 2 and Row 3 in the specific embodiment of FIG. 11). The switching unit 516 is configured to switch from outputting electrical power provided by the power supply module 502 to outputting electrical power provided by the redundancy power supply module 504 upon a disruption to the electrical power provided by the power supply module 502. In this way, were the power supply module 502 associated with a particular portion of the data hall 102 to fail, the switching unit would ensure that power from the redundancy power supply module 504 was provided to that portion of the data hall, to prevent a loss of power to the computer systems 552 within that portion of the data hall 102.

In a specific embodiment, each switching unit may be a static transfer switch or an automatic transfer switch or the like. A static transfer switch provides rapid transfer capability between power sources, with transfer times typically in the order of milliseconds. This rapid transfer time is sufficiently fast to prevent interruption to the power supply output downstream for the computer systems 522 in the data hall 102, as the transfer occurs faster than the hold-up time of the power supplies within the computer systems 522. An automatic transfer switch similarly provides automatic transfer capability between power sources, though typically with longer transfer times than a static transfer switch. The selection between a static transfer switch and an automatic transfer switch may be based on the criticality of the computing workloads and the tolerance of the computer systems 522 to brief power interruptions.

The power distribution system 500 further comprises a plurality of first power distribution units (PDUs), each associated with a respective one of the plurality of switching units. As shown in FIG. 11, first power distribution unit 518 is associated with switching unit 516, with the output terminal of the switching unit 516 connected to the first power distribution unit 518. The first power distribution unit 518 is configured to transfer electrical power output by the switching unit 516 to the one or more computer systems 522 within the associated portion of the data hall 102.

As shown in FIG. 11, the computer systems 522 may be arranged in one or more rows within the data hall 102, with each row preferably comprising racks of IT equipment in some embodiments. In a specific embodiment, each row may comprises 27 IT racks, however the specific number of racks can be chosen based on the specific data centner requirements. As discussed in relation to FIG. 4, each row may be configured to comprise computer systems with a specified power capacity. The row power capacity may be configured at 250 kW, 375 kW, or 750 kW average power per row, to accommodate different computing densities. Each row may also have a maximum power requirement that is higher than the average power, such as 300 kW maximum for a 250 kW average power row, 500 kW maximum for a 375 kW average power row, or 1000 kW maximum for a 750 kW average power row. The maximum power requirement represents the peak instantaneous power draw that the row is designed to accommodate, accounting for transient load spikes that may occur during operation.

In the embodiment illustrated in FIG. 11, the first power distribution unit 518 provides electrical power to Row 1, Row 2 and Row 3 of computer systems 522. However, in general the first power distribution unit 518 may supply any number of rows depending on the requirements of the data centre configuration. For example, in specific embodiments the first power distribution unit 518 may distribute the power output by the switching unit 516 to three rows, six rows, or twelve rows. The first power distribution unit 518 may include circuit breakers and monitoring equipment to protect the downstream computing equipment and provide visibility of power consumption at the row level.

In other embodiments, the first power distribution unit 518 may be omitted entirely, and the computer systems 522 may be fed directly from the output terminal of the switching unit 516.

In some embodiments, the power distribution system 500 may comprises only the components described above, namely the redundancy power supply module 504, a power supply module 502 for each portion of the data hall 102, and a switching unit 516 and first power distribution unit 518 associated with each power supply module 502 to serve the computer systems 522 within the associated portion of the data hall 102. However, in further embodiments, the power distribution system 500 may include additional components to provide further redundancy, as will now be discussed below.

For example, as shown in FIG. 11, each power supply module 502 may comprise a second output terminal 508 in addition to the first output terminal 506. A plurality of second power distribution units 524 may be included in the power distribution system 500, with each second power distribution unit 524 associated with one of the plurality of power supply modules 502 (and therefore also associated with the portion of the data hall 102 associated with that power supply module 502). Each second power distribution unit 524 is connected to the second output terminal 508 of the associated power supply module 502, and is configured to transfer electrical power output by the second output terminal 508 to the one or more computer systems 522 within the associated portion of the data hall 102 (i.e. to Row 1, Row 2 and Row 3 in the embodiment of FIG. 11).

Further, each row of computer systems 522 may comprise a first power supply busbar 526 and a second power supply busbar 528. The first power supply busbar 526 is configured to receive power from the first power distribution unit 518, and thus receives power from either the first output terminal 506 of the power supply module 502 or from the redundancy power supply module 504 via the switching unit 516. The second power supply busbar 528 is configured to receive power from the second power distribution unit 524, which receives power directly from the second output terminal 508 of the power supply module 502.

This dual-feed arrangement provides enhanced redundancy for the computer systems 522. The one or more computer systems 522 may be configured to selectively draw power from either the first power supply busbar 526 or the second power supply busbar 528, depending on which of the busbars 526 and 528 is providing a sufficient and stable electrical power. This selective drawing of power may be done at the IT rack level or individual computer level within each row. In this way, if the power supply from both the first output terminal 506 and the redundancy power supply module 504 were to fail such that no power was available via the switching unit 516 and first power distribution unit 518 (e.g. due to a failed switchboard at the first output terminal and a complete failure of the redundancy power supply module 504), the computer systems 522 could still receive electrical power via the second output terminal 508 and the second power distribution unit 524 via the second power supply busbar 528. Conversely, if the power supply from the second output terminal 508 were to fail (e.g. due to a failed switchboard at the second output terminal), power would still be available from the first output terminal 506 or from the redundancy power supply module 504 via the switching unit 516 via the first power supply busbar 526 . This dual-feed redundancy significantly enhances the reliability of the power supply to the computer systems 522 within the data hall 102.

In further embodiments, the power distribution system 500 may include additional components to enable power to be distributed to additional computer systems within each portion of the data hall 102.

For example, the power distribution system 500 may further comprise a plurality of additional switching units, with each additional switching unit associated with one of the plurality of power supply modules (and therefore also associated with the portion of the data hall 102 associated with that power supply module 502). For example, an additional switching unit 530 is shown in FIG. 11. The additional switching unit 530 comprises a first input terminal configured to receive electrical power from the first output terminal 506 of the power supply module 502. The first output terminal 506 is thus connected to input terminals of both the switching unit 516 and additional switching unit 530. In some embodiments, the first output terminal 506 may be connected to both the first input terminal of the switching unit 516 and the first input terminal of the additional switching unit 530 via a primary busbar 532.

The additional switching unit 530 further comprises a second input terminal configured to receive electrical power from the redundancy power supply module 504. The redundancy power supply module 504 may be connected to the second input terminal of the additional switching unit 530 via a busbar, such as the same the redundancy busbar 520 that connects the redundancy power supply module 504 and the switching unit 516.

The additional switching unit 530 further comprises an output terminal configured to output electrical power to one or more additional computer systems within the associated portion of the data hall 102 (Row 4, Row 5 and Row 6 in the embodiment of FIG. 11). The additional switching unit 530 is configured to switch from outputting electrical power provided by the power supply module 502 to outputting electrical power provided by the redundancy power supply module 504 upon a disruption to the electrical power provided by the power supply module 502. The additional switching unit 530 may be a static transfer switch or an automatic transfer switch or the like.

The power distribution system 500 may further comprise a plurality of third power distribution units, each associated with the one of the additional switching units. For example, in FIG. 11 a third power distribution unit 534 is associated with the additional switching unit 530 (and therefore also the associated portion of the data hall 102). The output terminal of the additional switching unit 530 is connected to the third power distribution unit 534. The third power distribution unit 534 is configured to transfer electrical power output by the additional switching unit 530 to the additional computer systems within the associated portion of the data hall 102 (i.e. to Row 4, Row 5 and Row 6 in FIG. 11), analogously to as done by the first power distribution unit 518.

The power distribution system 500 may further comprise a plurality of fourth power distribution units, each associated with the one of the additional switching units. For example, in FIG. 11 a fourth power distribution unit 536 is associated with the power supply module 502 (and therefore also the associated portion of the data hall 102). The fourth power distribution unit 536 is connected to the third output terminal 510 of the power supply module 502, and configured to transfer electrical power output by the third output terminal 510 to the one or more additional computer systems (i.e. to Row 4, Row 5 and Row 6 in FIG. 11) within the associated portion of the data hall 102.

As described above for the first power supply busbar 526 and second power supply busbar 528, each of the rows of additional computer systems (Row 4, Row 5 and Row 6 in FIG. 11) may similarly comprise a first power supply busbar configured to receive power from the third power distribution unit 534, and a second power supply busbar configured to receive power from the fourth power distribution unit 536. The first power supply busbar of each row of additional computer systems receives power from either the first output terminal 506 of the power supply module 502 or from the redundancy power supply module 504 via the additional switching unit 530 and the third power distribution unit 534. The second power supply busbar of each row of additional computer systems receives power directly from the third output terminal 510 of the power supply module 502 via the fourth power distribution unit 536. The one or more additional computer systems may be configured to selectively draw power from either the first power supply busbar or the second power supply busbar, providing dual-feed redundancy analogously to as described previously.

Thus, the additional switching unit 530, the third power distribution unit 534, and the fourth power distribution unit 536 essentially replicate the functionality of the switching unit 516, the first power distribution unit 518, and the second power distribution unit 524 respectively. This arrangement partitions the computer systems within each portion of the data hall 102 into two groups: a first group (Rows 1 to 3 in FIG. 11) served by the switching unit 516, the first power distribution unit 518, and the second power distribution unit 524; and a second group (Rows 4 to 6 in FIG. 11) served by the additional switching unit 530, the third power distribution unit 534, and the fourth power distribution unit 536. Each group receives the same dual-feed redundancy capability, with power available from either the associated power supply module 502 or the redundancy power supply module 504 via the respective switching unit, whilst also having a separate power feed directly from the power supply module 502 via the respective second or fourth power distribution unit.

The provision of both the switching unit 516 and the additional switching unit 530 therefore enables the rows of computer systems within each portion of the data hall 102 to be partitioned into two groups. This partitioning arrangement provides several advantages. Firstly, the arrangement facilitates maintenance operations, as maintenance or replacement of one switching unit affects only the rows served by that switching unit rather than all rows within the portion of the data hall 102. Thus maintenance can be performed on one group of rows without requiring shutdown of the other group. Secondly, the partitioning reduces the electrical load carried by each component, including each switching unit and each power supply busbar. This enables smaller, lower power rated components to be used, reducing cost and complexity. For example, in some embodiments, partitioning to two groups of three rows can allow lower power busbars, such as 630 amp busbars, to be used as the power supply busbars 526 and 528 within each row.

In general, the number of rows and power specifications for the one or more rows of additional computer systems (Rows 4 to 6) may be the same as the one or more rows of computer systems (Rows 1 to 3). For example, the one or more additional computer systems may be arranged three rows, six rows, or twelve rows, and each row of additional computer systems may comprises computer systems that require an average power of 250 kW, 375 kW, or 750 kW, have a maximum power requirement of 300 kW, 500 kW, or 1000 kW, or both.

Further, in some embodiment further partitioning of the computer systems may be possible. For example, in some embodiments each power supply module could have three or more switching units associated with it, to partition the computer systems into three groups. In general, any number of switching units may be used with each power supply module.

As shown in FIG. 11, each power supply module 502 within the power distribution system 500 may further comprise one or more additional output terminals configured to output electrical power (the second power supply stream) to plant equipment 538 within the data centre. As shown in FIG. 11, the power supply module 502 comprises an additional output terminal 512 configured to output electrical power to plant equipment 538. As discussed above, such plant equipment may also be referred to as building services equipment, and relates to any equipment other than the IT equipment (i.e. other than to the one or more computer systems and additional computer systems 522). In some embodiments, such plant equipment 538 may include heating, ventilation, and/or air conditioning equipment, loading bay equipment, Meet-Me Room equipment (i.e. networking equipment), equipment in the administrative building of the data centre, and/or equipment in the logistic building of the data centre. This arrangement enables the power supply modules 502 to provide power for building services and mechanical equipment in addition to the IT equipment, ensuring that all power requirements of the data centre are met by the modular power supply infrastructure. The separation of IT load from plant equipment load via separate output terminals enables independent management of power allocation and ensures that plant equipment does not draw power from the IT allocation. Similarly, the redundancy power supply module 504 may also comprise one or more additional output terminals (not shown in FIG. 11) configured to output electrical power to plant equipment within the data centre.

In general, each of the first output terminal 506, the second output terminal 508, and the third output terminal 510 of each power supply module 502 may each exit from a switchboard within that power supply module 502. In some embodiments, the first output terminal 506, the second output terminal 508, and the third output terminal 510 may all be connected to a shared switchboard, such as the main switchboard 336 described in relation to FIG. 10. Alternatively, each of the first output terminal 506, the second output terminal 508, and the third output terminal 510 may be connected to separate dedicated switchboards within the power supply module 502. Further, the additional output terminal 512 may similarly be connected to a switchboard within the power supply module 502, such as the second switchboard 342 described in relation to FIG. 10. Similarly, the output terminal 514 of the redundancy power supply module 504 may be connected to a switchboard within the redundancy power supply module 504.

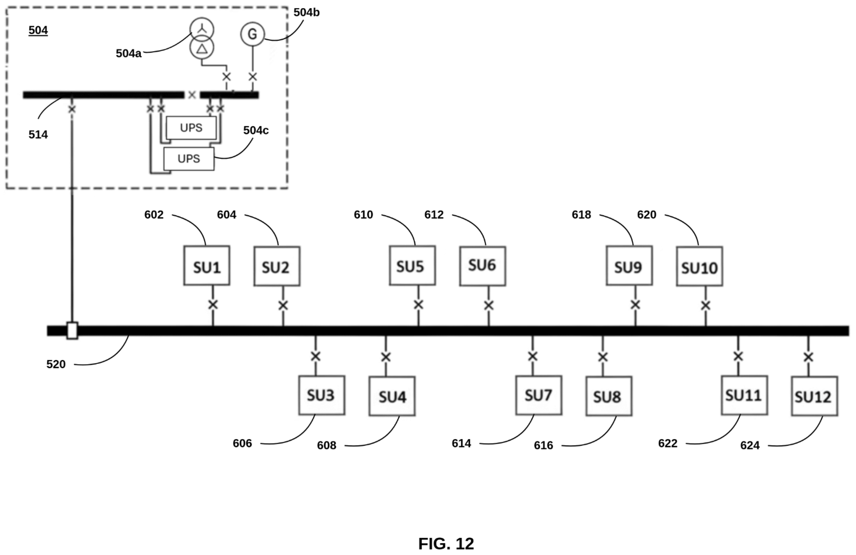

As mentioned above, FIG. 11 illustrates only a single power supply module 502 for clarity, however the power distribution system 500 comprises a plurality of power supply modules 502, with a redundancy power supply module 504 configured to provide backup power capability to each of the power supply modules 502. FIG. 12 illustrates this arrangement, showing exemplary connections of a redundancy power supply module 504 in a power distribution system according to an embodiment where the redundancy power supply module 504 provides back up power for six power supply modules 502. As mentioned previously in some embodiments each of the six power supply modules 502 may be identical, to improve the modular nature of the data centre.

In FIG. 12, the output terminal 514 of the redundancy power supply module 504 is connected to the redundancy busbar 520 (which may also be referred to as a catcher busbar). The redundancy busbar 520 is configured to distribute electrical power from the redundancy power supply module 504 to each of the plurality of switching units and additional switching units associated with the six power supply modules 502.

Specifically, in the embodiment of FIG. 12, the redundancy busbar 520 is connected to the second input terminal of each of a first switching unit 602, a second switching unit 604, a third switching unit 606, a fourth switching unit 608, a fifth switching unit 610, a sixth switching unit 612, a seventh switching unit 614, an eighth switching unit 616, a ninth switching unit 618, a tenth switching unit 620, an eleventh switching unit 622, and a twelfth switching unit 624.

Each of the first switching unit 602, third switching unit 606, fifth switching unit 610, seventh switching unit 614, ninth switching unit 618 and eleventh switching unit 622 are associated with a respective one of the six power supply modules 502, and function as the switching unit 516 described in FIG. 11 for their respective power supply module 502.

Each of the second switching unit 604, fourth switching unit 608, sixth switching unit 612, eighth switching unit 616, tenth switching unit 620, and twelfth switching unit 624 are associated with a respective one of the six power supply modules 502, and function as the additional switching unit 530 described in FIG. 11 for their respective power supply module 502.

In this way, the twelve switching units in FIG. 12 correspond to six portions of the data hall 102, with each portion having two switching units associated with it (analogous to the switching unit 516 and the additional switching unit 530 described in relation to FIG. 11). For example, the first switching unit 602 and the second switching unit 604 may be associated with a first portion of the data hall 102, the third switching unit 606 and the fourth switching unit 608 may be associated with a second portion of the data hall 102, and so forth. In this arrangement, the redundancy power supply module 504 provides backup power capability for six portions of the data hall 102 (N=6 as discussed previously), with each portion having dual switching units to partition the computer systems within that portion into two groups as described in relation to FIG. 11.

As discussed previously, the configuration of FIG. 12 enables the redundancy power supply module 504 to serve as a shared backup power source each of the six power supply modules, and thus for each of the six portions of the data hall 102 associated with those power supply modules, providing redundancy without requiring duplication of the entire power supply infrastructure for each portion.

In general, although each portion of the data hall 102 is described above as having one associated power supply modules, each portion of the data hall 102 may have more than one power supply module 502 associated with it in some embodiments. For example, a portion of the data hall 102 may have two or more power supply modules 502 providing power to the computer systems within that portion, with each power supply module 502 serving different rows or groups of rows within the portion. This arrangement enables higher power densities to be supported within each portion of the data hall 102, as the total power capacity available to that portion is the combined capacity of the multiple associated power supply modules 502.

Furthermore, in some embodiments, multiple redundancy power supply modules 504 may be provided for each group of N portions of the data hall 102. For example, two or more redundancy power supply modules 504 may be connected to the same redundancy busbar 520, such that the redundancy busbar 520 receives power from multiple redundancy power supply modules 504 simultaneously. This arrangement provides enhanced redundancy capability, as the failure of one redundancy power supply module 504 would not result in a total loss of backup power. Additionally, the provision of multiple redundancy power supply modules 504 connected to the same redundancy busbar 520 enables the backup power capacity to be increased.

### Method for Distributing Power

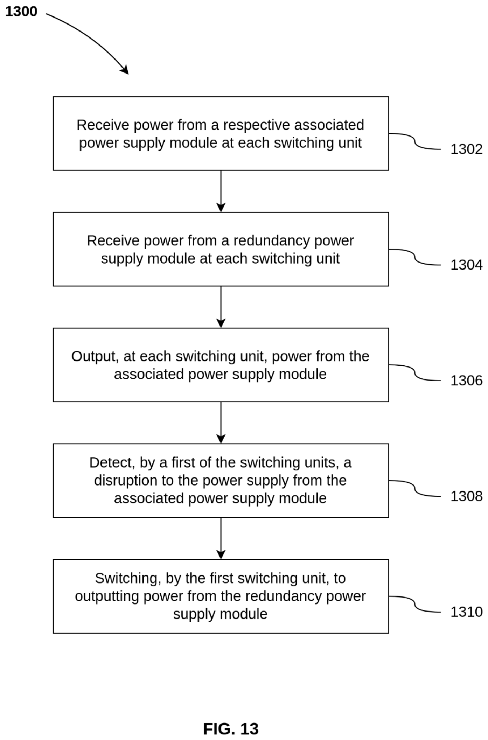

FIG. 13 illustrates a flowchart of a method 1300 for distributing power in the modular data centre 100.

The method 1300 includes a step 1302 of receiving, by each of a plurality of switching units, electrical power from a respective power supply module 502 associated with that switching unit. As described above in relation to FIGs. 11 and 12, each switching unit (such as the switching unit 516) comprises a first input terminal configured to receive electrical power from the first output terminal 506 of the associated power supply module 502.

The method 1300 includes a step 1304 of receiving, by each of the plurality of switching units, electrical power from the redundancy power supply module 504. As described previously, each switching unit comprises a second input terminal configured to receive electrical power from the redundancy power supply module 504 via the redundancy busbar 520.

The method 1300 includes a step 1306 of outputting, by each of the plurality of switching units, the electrical power received from the associated power supply module 502 for one or more computer systems 522 within a portion of the data hall 102 that is associated with that switching unit and the associated power supply module 502. During normal operation, each switching unit outputs electrical power received from the associated power supply module 502 to the computer systems 522 within the associated portion of the data hall 102.

The method 1300 includes a step 1308 of detecting, by a first of the plurality of switching units, a disruption to the electrical power received by that switching unit from the associated power supply module 502. The disruption may comprise a failure of the external power supply, a failure of the generator unit 502b, a fault in the electrical distribution equipment within the power supply module 502, or any other event that causes the electrical power at the first input terminal of the switching unit to fall outside acceptable voltage or frequency parameters.

The method 1300 includes a step 1310 of switching, by the first of the plurality of switching units in response to the detecting, to outputting the electrical power received from the redundancy power supply module 504 to the one or more computer systems 522. The switching is performed automatically by the switching unit upon detection of the disruption, with transfer times sufficiently rapid to prevent interruption to the computer systems 522.

Features of any of the examples or embodiments outlined above may be combined to create additional examples or embodiments without losing the intended effect. It should be understood that the description of an embodiment or example provided above is by way of example only, and various modifications could be made by one skilled in the art. Furthermore, one skilled in the art will recognise that numerous further modifications and combinations of various aspects are possible. Accordingly, the described aspects are intended to encompass all such alterations, modifications, and variations that fall within the scope of the appended claims.

The following numbered clauses set out certain combinations of features contemplated by the present disclosure:
1. A power distribution system for a modular data centre, the modular data centre having a data hall for housing a plurality of computer systems, the data hall having a first end portion, a second end portion, and one or more middle portions arranged in a repeating linear fashion between the first end portion and the second end portion so as to form the data hall, the power distribution system comprising: a plurality of power supply modules, wherein each power supply module is associated with a respective one of the portions of the data hall; a plurality of switching units, wherein each switching unit is associated with a respective one of the plurality of power supply modules and the associated portion of the data hall, and wherein each switching unit comprises a first input terminal configured to receive electrical power from a first output terminal of the associated power supply module; and a redundancy power supply module configured to output electrical power to a second input terminal of each of the plurality of switching units; wherein each switching unit further comprises an output terminal configured to output electrical power for one or more computer systems within the associated portion of the data hall, and wherein each switching unit is configured to switch from outputting electrical power provided by the associated power supply module to outputting electrical power provided by the redundancy power supply module upon a disruption to the electrical power provided by the associated power supply module.
2. The power distribution system of clause 1, wherein each of the power supply modules and/or the redundancy power supply module comprises: an external supply input terminal configured to receive electrical power from an external power supply; and a transformer configured to convert a voltage of the electrical power received from the external power supply.
3. The power distribution system of clause 2, wherein the external power supply is a utility power supply or a grid power supply.
4. The power distribution system of clause 2 or 3, wherein each of the power supply modules and/or the redundancy power supply module comprises: a generator unit configured to provide power during a failure of the external power supply.
5. The power distribution system of clause 4, wherein the generator unit provides a power between 1.5MW and 10MW, preferably between 2MW and 5MW, more preferably wherein the generator unit is a 2.4MW generator.
6. The power distribution system of any preceding clause, wherein the first output terminal of each power supply module is connected to a switchboard within that power supply module.
7. The power distribution system of any preceding clause, wherein the first output terminal of each power supply module is coupled to one or more uninterruptible power supply systems within that power supply module.
8. The power distribution system of any preceding clause, wherein each of the plurality of power supply modules are identical.
9. The power distribution system of any preceding clause, wherein each of the plurality of power supply modules is structurally separate from the associated portion of the data hall.
10. The power distribution system of any preceding clause, wherein the redundancy power supply module is structurally separate from the data hall.
11. The power distribution system of any preceding clause, wherein the redundancy power supply module is connected to the second input terminal of each of the plurality of switching units via a redundancy busbar.
12. The power distribution system of any preceding clause, wherein each of the plurality of switching units is a static transfer switch or an automatic transfer switch.
13. The power distribution system of any preceding clause, further comprising: a plurality of first power distribution units, wherein each first power distribution unit is associated with a respective one of the plurality of switching units and the associated portion of the data hall; wherein the output terminal of each switching unit is connected to the associated first power distribution unit; and wherein each first power distribution unit is configured to transfer electrical power output by the associated switching unit to the one or more computer systems within the associated portion of the data hall.
14. The power distribution system of clause 13, further comprising: a plurality of second power distribution units, wherein each second power distribution unit is associated with a respective one of the plurality of power supply modules and the associated portion of the data hall; wherein each power supply module comprises a second output terminal, and each second power distribution unit is connected to the second output terminal of the associated power supply module; and wherein each second power distribution unit is configured to transfer electrical power output by the second output terminal of the associated power supply module to the one or more computer systems within the associated portion of the data hall.
15. The power distribution system of clause 14, wherein the second output terminal of each power supply module is connected to a switchboard within that power supply module.
16. The power distribution system of clause 14 or 15, wherein the second output terminal of each power supply module is coupled to one or more uninterruptible power supply systems within that power supply module.
17. The power distribution system of any preceding clause, wherein the one or more computer systems are arranged in one or more rows, preferably in three rows, six rows, or twelve rows.
18. The power distribution system of clause 17, wherein each row comprises computer systems that either: require an average power of 250 kW, 375 kW, or 750 kW; have a maximum power requirement of 300 kW, 500kW, or 1000kW; or both.
19. The power distribution system of clause 17 or 18, when dependent on clause 13, wherein each of the one or more rows comprises a first power supply busbar configured to receive power from the first power distribution unit.
20. The power distribution system of any of clauses 17 to 19, when dependent on clause 14, wherein each of the one or more rows comprises a second power supply busbar configured to receive power from the second power distribution unit.
21. The power distribution system of clause 20, wherein the one or more computer systems are configured to selectively draw power from either the first power supply busbar or the second power supply busbar.
22. The power distribution system of any preceding clause, further comprising: a plurality of additional switching units, wherein each additional switching unit is associated with a respective one of the power supply modules and the associated portion of the data hall; wherein each additional switching unit comprises a first input terminal configured to receive electrical power from the first output terminal of the associated power supply module; wherein each additional switching unit comprises a second input terminal configured to receive electrical power from the redundancy power supply module; and wherein each additional switching unit further comprises an output terminal configured to output electrical power to one or more additional computer systems within the associated portion of the data hall, and wherein each additional switching unit is configured to switch from outputting electrical power provided by the associated power supply module to outputting electrical power provided by the redundancy power supply module upon a disruption to the electrical power provided by the associated power supply module.
23. The power distribution system of clause 22, wherein each of the plurality of additional switching units is a static transfer switch or an automatic transfer switch.
24. The power distribution system of clause 22 or 23, wherein for each of the power supply modules the first output terminal is connected to both the first input terminal of the associated switching unit and the first input terminal of the associated additional switching unit via a primary busbar.
25. The power distribution system of any of clauses 22 to 24, when dependent on clause 11, wherein the redundancy power supply module is connected to the second input terminal of each of the plurality of additional switching units via the redundancy busbar.
26. The power distribution system of any of clauses 22 to 25, further comprising: a plurality of third power distribution units, wherein each third power distribution unit is associated with a respective one of the plurality of additional switching units and the associated portion of the data hall; wherein the output terminal of each additional switching unit is connected to the associated third power distribution unit; and wherein each third power distribution unit is configured to transfer electrical power output by the associated additional switching unit to the one or more additional computer systems within the associated portion of the data hall.
27. The power distribution system of clause 26, further comprising: a plurality of fourth power distribution units, wherein each fourth power distribution unit is associated with a respective one of the plurality of power supply modules and the associated portion of the data hall; wherein each power supply module comprises a third output terminal, and each fourth power distribution unit is connected to the third output terminal of the associated power supply module; and wherein each fourth power distribution unit is configured to transfer electrical power output by the third output terminal of the associated power supply module to the one or more additional computer systems within the associated portion of the data hall.
28. The power distribution system of clause 27, wherein the third output terminal of each power supply module is connected to a switchboard within that power supply module.
29. The power distribution system of clause 27 or 28, wherein the third output terminal of each power supply module is coupled to one or more uninterruptible power supply systems within that power supply module.
30. The power distribution system of any of clauses 22 to 29, wherein the one or more additional computer systems are arranged in one or more rows, preferably in three rows, six rows, or twelve rows.
31. The power distribution system of clause 30, wherein each row comprises computer systems that either: require an average power of 250 kW, 375 kW, or 750 kW; have a maximum power requirement of 300 kW, 500kW, or 1000kW; or both.
32. The power distribution system of clause 30 or 31, when dependent on clause 26, wherein each of the one or more rows of additional computer systems comprises a first power supply busbar configured to receive power from the third power distribution unit.
33. The power distribution system of any of clauses 30 to 32, when dependent on clause 27, wherein each of the one or more rows of additional computer systems comprises a second power supply busbar configured to receive power from the fourth power distribution unit.
34. The power distribution system of clause 33, wherein the one or more additional computer systems are configured to selectively draw power from either the first power supply busbar or the second power supply busbar.
35. The power distribution system of any preceding clause, wherein each of the power supply modules and/or the redundancy power supply module comprises one or more additional output terminals configured to output electrical power to plant equipment within the data centre.
36. The power distribution system of clause 35, wherein the plant equipment comprises: heating, ventilation, and/or air conditioning equipment, loading bay equipment, Meet-Me Room equipment, equipment in an administrative building of the data centre, equipment in a logistic building of the data centre, or any combination thereof.
37. The power distribution system of any preceding clause, wherein each of the power supply modules and/or the redundancy power supply module is configured to provide either or both of 1.5 MW of IT power and 2.4 MW of total power.
38. The power distribution system of any preceding clause, wherein the data centre is configured to provide an IT power of 1.5 MW, 3 MW, 4.5 MW, 9 MW, 18 MW, 27 MW, 36 MW, 45 MW, 54 MW, 72MW or 108 MW.
39. A method for distributing power in a modular data centre, the modular data centre having a data hall for housing a plurality of computer systems, the data hall having a first end portion, a second end portion, and one or more middle portions arranged in a repeating linear fashion between the first end portion and the second end portion so as to form the data hall, the method comprising the steps of: receiving, by each of a plurality of switching units, electrical power from a respective power supply module associated with that switching unit; receiving, by each of the plurality of switching units, electrical power from a redundancy power supply module; outputting, by each of the plurality of switching units, the electrical power received from the associated power supply module for one or more computer systems within a portion of the data hall that is associated with that switching unit and the associated power supply module; detecting, by a first of the plurality of switching units, a disruption to the electrical power received by that switching unit from the associated power supply module; and switching, by the first of the plurality of switching units in response to the detecting, to outputting the electrical power received from the redundancy power supply module to the one or more computer systems.

## Claims

1. A power distribution system for a modular data centre, the modular data centre having a data hall for housing a plurality of computer systems, the data hall having a first end portion, a second end portion, and one or more middle portions arranged in a repeating linear fashion between the first end portion and the second end portion so as to form the data hall, the power distribution system comprising:
a plurality of power supply modules, wherein each power supply module is associated with a respective one of the portions of the data hall;
a plurality of switching units, wherein each switching unit is associated with a respective one of the plurality of power supply modules and the associated portion of the data hall, and wherein each switching unit comprises a first input terminal configured to receive electrical power from a first output terminal of the associated power supply module; and
a redundancy power supply module configured to output electrical power to a second input terminal of each of the plurality of switching units;
wherein each switching unit further comprises an output terminal configured to output electrical power for one or more computer systems within the associated portion of the data hall, and wherein each switching unit is configured to switch from outputting electrical power provided by the associated power supply module to outputting electrical power provided by the redundancy power supply module upon a disruption to the electrical power provided by the associated power supply module.

2. The power distribution system of claim 1, wherein each of the power supply modules and/or the redundancy power supply module comprises:
an external supply input terminal configured to receive electrical power from an external power supply, preferably wherein the external power supply is a utility power supply or a grid power supply;
a transformer configured to convert a voltage of the electrical power received from external power supply; and optionally
a generator unit configured to provide power during a failure of the external power supply.

3. The power distribution system of any preceding claim, wherein:
the first output terminal of each power supply module is connected to a switchboard within that power supply module; and/or
the first output terminal of each power supply module is coupled to one or more uninterruptible power supply systems within that power supply module.

4. The power distribution system of any preceding claim, wherein each of the plurality of power supply modules are identical.

5. The power distribution system of any preceding claim, wherein each of the plurality of power supply modules is structurally separate from the associated portion of the data hall and/or the redundancy power supply module is structurally separate from the data hall.

6. The power distribution system of any preceding claim, wherein the redundancy power supply module is connected to the second input terminal of each of the plurality of switching units via a redundancy busbar.

7. The power distribution system of any preceding claim, wherein each of the plurality of switching units is a static transfer switch or an automatic transfer switch.

8. The power distribution system of any preceding claim, further comprising:
a plurality of first power distribution units, wherein each first power distribution unit is associated with a respective one of the plurality of switching units and the associated portion of the data hall;
wherein the output terminal of each switching unit is connected to the associated first power distribution unit; and
wherein each first power distribution unit is configured to transfer electrical power output by the associated switching unit to the one or more computer systems within the associated portion of the data hall.

9. The power distribution system of claim 8, further comprising:
a plurality of second power distribution units, wherein each second power distribution unit is associated with a respective one of the plurality of power supply modules and the associated portion of the data hall;
wherein each power supply module comprises a second output terminal, and each second power distribution unit is connected to the second output terminal of the associated power supply module; and
wherein each second power distribution unit is configured to transfer electrical power output by the second output terminal of the associated power supply module to the one or more computer systems within the associated portion of the data hall.

10. The power distribution system of claim 9, wherein:
the second output terminal of each power supply module is connected to a switchboard within that power supply module; and/or
the second output terminal of each power supply module is coupled to one or more uninterruptible power supply systems within that power supply module.

11. The power distribution system of any preceding claim, wherein the one or more computer systems are arranged
in one or more rows, preferably in three rows, six rows, or twelve rows,
preferably wherein each row comprises computer systems that either:
require an average power of 250 kW, 375 kW, or 750 kW;
have a maximum power requirement of 300 kW, 500kW, or 1000kW;
or both.

12. The power distribution system of claim 11, when dependent on claim 8, wherein each of the one or more rows comprises a first power supply busbar configured to receive power from the first power distribution unit.

13. The power distribution system of claims 11 or 12, when dependent on claim 9, wherein:
each of the one or more rows comprises a second power supply busbar configured to receive power from the second power distribution unit,
preferably wherein the one or more computer systems are configured to selectively draw power from either the first power supply busbar or the second power supply busbar.

14. The power distribution system of any preceding claim, wherein:
each of the power supply modules and/or the redundancy power supply module comprises one or more additional output terminals configured to output electrical power to plant equipment within the data centre,
preferably wherein the plant equipment comprises: heating, ventilation, and/or air conditioning equipment, loading bay equipment, Meet-Me Room equipment, equipment in an administrative building of the data centre, equipment in a logistic building of the data centre, or any combination thereof.

15. A method for distributing power in a modular data centre, the modular data centre having a data hall for housing a plurality of computer systems, the data hall having a first end portion, a second end portion, and one or more middle portions arranged in a repeating linear fashion between the first end portion and the second end portion so as to form the data hall, the method comprising the steps of:
receiving, by each of a plurality of switching units, electrical power from a respective power supply module associated with that switching unit;
receiving, by each of the plurality of switching units, electrical power from a redundancy power supply module;
outputting, by each of the plurality of switching units, the electrical power received from the associated power supply module for one or more computer systems within a portion of the data hall that is associated with that switching unit and the associated power supply module;
detecting, by a first of the plurality of switching units, a disruption to the electrical power received by that switching unit from the associated power supply module; and
switching, by the first of the plurality of switching units in response to the detecting, to outputting the electrical power received from the redundancy power supply module to the one or more computer systems.
